# EUROPEAN PATENT APPLICATION

(11) **EP 4 398 038 A1**
(43) Date of publication of application: **10.07.2024**
(21) Application number: 22864331.8
(22) Date of filing: 23.08.2022
(51) Int. Cl.: G03F 7/26

(54) **RECYCLING TREATMENT DEVICE, WASHING-OUT DEVICE, AND METHOD FOR MANUFACTURING FLEXOGRAPHIC PRINTING PLATE**

(30) Priority: 31.08.2021 JP 2021141366
(71) Applicant: FUJIFILM Corporation, Tokyo 106-8620 (JP)
(72) Inventor: TAJIMA, Seiji, Haibara-gun, Shizuoka 421-0396 (JP); MOGI, Fumio, Haibara-gun, Shizuoka 421-0396 (JP)
(74) Representative: HGF
(86) International application number: PCT/JP2022/031679
(87) International publication number: WO 2023/032747

(57) **Abstract**

There are provided a regeneration treatment apparatus, a washout processor, and a manufacturing method of a flexographic printing plate in which attachment of a resin aggregate generated as a non-exposed portion of an imagewise exposed flexographic printing plate precursor is removed through development using a washing solution can be suppressed and the resin aggregate can be easily cleaned off even in a case of being attached. The regeneration treatment apparatus removes, from a used washing solution containing the resin aggregate generated as the non-exposed portion of the imagewise exposed flexographic printing plate precursor having a photosensitive resin layer is removed through development using the washing solution of which a main component is water, the resin aggregate. The regeneration treatment apparatus has a centrifuge that has a rotating body for separating out the resin aggregate from the used washing solution and an induction path through which the resin aggregate from the centrifuge passes. A portion in contact with the resin aggregate has a critical surface tension of 31 mN/m or less and a dynamic friction coefficient of 0.2 or less.

## Description

### BACKGROUND OF THE INVENTION

### 1. Field of the Invention

The present invention relates to a regeneration treatment apparatus for a used washing solution containing a resin aggregate generated as a non-exposed portion of an imagewise exposed flexographic printing plate precursor having a photosensitive resin layer is removed through development using the washing solution, a washout processor that performs development using the washing solution, and a manufacturing method of a flexographic printing plate.

### 2. Description of the Related Art

Various types of methods are known as developing methods for a printing plate formed of a photosensitive resin plate. For example, in a developing method of performing development using a water-based washing solution of which a main component is water, development is performed by applying the water-based washing solution to an imagewise exposed photosensitive resin plate with a brush or the like and washing out an uncured resin or the like, which is a non-exposed portion. In this case, there is the uncured resin or the like in the water-based washing solution in a state of being dispersed as solid contents. Reusing the water-based washing solution, which is in a state where the uncured resin or the like is dispersed, by removing the uncured resin, which is the dispersed solid contents, is proposed. The water-based washing solution is also referred to as a developer.

For example, a method of using a centrifugal filter unit used in separating out solid substances from a waste washing solution containing a washable photosensitive resin liquid from a printing plate manufacturing step is described in JP1994-504230A (JP-H6-504230A). The filter unit has a solid substance collector that is disposed to be rotatable and that is arranged such that the solid substances are deposited during rotation. The collector is provided to be removable from the filter unit while maintaining a relationship between the collector and the solid substances deposited thereon.

### SUMMARY OF THE INVENTION

Herein, in a case of developing a flexographic printing plate precursor using a washing solution, a non-exposed portion is removed, and solid contents are dispersed in the washing solution as the non-exposed portion is removed. In a case where accumulation of the solid contents advances, a resin aggregate is generated. Since the resin aggregate is fixed to an inner wall of a developing tank, particularly near a gas-liquid interface with the washing solution of the developing tank, it is necessary to periodically clean the developing tank in order to remove the resin aggregate. The solid contents described above are the same as the solid substances of JP1994-504230A (JP-H6-504230A).

In addition, in JP1994-504230A (JP-H6-504230A), the solid substances are separated out in combination of the centrifugation and the filter unit. Even in a state where the solid substances are filtered out by the filter unit, in a case where the amount of a filtrate increases, a large amount of solid substances pass through the inside of a pipe through which the filtrate passes, the solid substances aggregate in the pipe, and a resin aggregate is generated. In this case, as in the developing tank described above, it is also necessary to periodically clean the pipe, such as removing the resin aggregate or the like. In a case where cleaning frequency increases, a work load caused by cleaning increases. In addition thereto, in a case where the cleaning frequency increases, a time for which development is stopped increases, and production efficiency of development of the flexographic printing plate precursor decreases. For this reason, it is desirable to make it possible to suppress attachment of the resin aggregate and to easily clean off the resin aggregate even in a case where the resin aggregate is attached.

An object of the present invention is to provide a regeneration treatment apparatus, a washout processor, and a manufacturing method of a flexographic printing plate in which attachment of a resin aggregate generated as a non-exposed portion of an imagewise exposed flexographic printing plate precursor having a photosensitive resin layer is removed through development using a washing solution can be suppressed and the resin aggregate can be easily cleaned off even in a case of being attached.

According to an aspect of the present invention, in order to achieve the object described above, there is provided a regeneration treatment apparatus that from a used washing solution containing a resin aggregate generated as a non-exposed portion of an imagewise exposed flexographic printing plate precursor having a photosensitive resin layer is removed through development using a washing solution of which a main component is water, removes the resin aggregate, the regeneration treatment apparatus comprising a centrifuge that has a rotating body for separating out the resin aggregate from the used washing solution and an induction path through which the resin aggregate from the centrifuge passes, in which a portion in contact with the resin aggregate has a critical surface tension of 31 mN/m or less and a dynamic friction coefficient of 0.2 or less.

It is preferable that the portion in contact with the resin aggregate is a portion in contact with the resin aggregate once or repeatedly.

It is preferable that the portion in contact with the resin aggregate is the induction path.

It is preferable that the portion in contact with the resin aggregate is composed of at least one selected from groups consisting of perfluoroalkoxy alkane, polytetrafluoroethylene, and polyethylene having an average molecular weight of 700,000 or more.

It is preferable that the portion in contact with the resin aggregate is composed of polyethylene having an average molecular weight of 750,000 to 6,000,000.

According to another aspect of the present invention, there is provided a regeneration treatment apparatus that from a used washing solution containing a resin aggregate generated as a non-exposed portion of an imagewise exposed flexographic printing plate precursor having a photosensitive resin layer is removed through development using a washing solution of which a main component is water, removes the resin aggregate, in which a portion in contact with the resin aggregate is composed of polyethylene having an average molecular weight of 750,000 to 6,000,000.

It is preferable that the portion in contact with the resin aggregate is a portion in contact with the resin aggregate once or repeatedly.

According to still another aspect of the present invention, there is provided a washout processor comprising the regeneration treatment apparatus.

According to still another aspect of the present invention, there is provided a washout processor that develops an imagewise exposed flexographic printing plate precursor having a photosensitive resin layer using a washing solution of which a main component is water, in which a portion in contact with a used washing solution which contains a resin aggregate generated as a non-exposed portion of the imagewise exposed flexographic printing plate precursor is removed has a critical surface tension of 31 mN/m or less and a dynamic friction coefficient of 0.2 or less.

It is preferable that a portion in contact with the resin aggregate is composed of at least one selected from groups consisting of perfluoroalkoxy alkane, polytetrafluoroethylene, and polyethylene having an average molecular weight of 700,000 or more.

It is preferable that a portion in contact with the resin aggregate is composed of at least one selected from groups consisting of polyethylene having an average molecular weight of 750,000 to 6,000,000.

According to still another aspect of the present invention, there is provided a washout processor that develops an imagewise exposed flexographic printing plate precursor having a photosensitive resin layer using a washing solution of which a main component is water, in which a portion in contact with a used washing solution which contains a resin aggregate generated as a non-exposed portion of the imagewise exposed flexographic printing plate precursor is removed is composed of polyethylene having an average molecular weight of 750,000 to 6,000,000.

It is preferable that a portion in contact with the resin aggregate is a portion in contact with the resin aggregate once or repeatedly.

It is preferable that a developing tank that develops an imagewise exposed flexographic printing plate precursor is further included and a portion in contact with the resin aggregate is a gas-liquid interface of the washing solution at an inner wall surface of the developing tank.

According to still another aspect of the present invention, there is provided a manufacturing method of a flexographic printing plate, the manufacturing method including developing an imagewise exposed flexographic printing plate precursor using the used washing solution from which the resin aggregate is removed using the regeneration treatment apparatus.

According to still another aspect of the present invention, there is provided a manufacturing method, the manufacturing method including a flexographic printing plate of developing an imagewise exposed flexographic printing plate precursor using the washout processor.

With the present invention, it is possible to provide the regeneration treatment apparatus, the washout processor, and the manufacturing method of a flexographic printing plate in which attachment of the resin aggregate generated as the non-exposed portion of the imagewise exposed flexographic printing plate precursor having the photosensitive resin layer is removed through development using the washing solution can be suppressed and the resin aggregate can be easily cleaned off even in a case of being attached.

### BRIEF DESCRIPTION OF THE DRAWINGS

Fig. 1 is a schematic view showing an example of a treatment system having a washout processor and a regeneration treatment apparatus according to an embodiment of the present invention.
Fig. 2 is a schematic view showing a step of a treatment method using the regeneration treatment apparatus according to the embodiment of the present invention.
Fig. 3 is a schematic view showing a step of the treatment method using the regeneration treatment apparatus according to the embodiment of the present invention.
Fig. 4 is a schematic view showing a step of the treatment method using the regeneration treatment apparatus according to the embodiment of the present invention.
Fig. 5 is a schematic view showing a step of the treatment method using the regeneration treatment apparatus according to the embodiment of the present invention.
Fig. 6 is a schematic side view showing a second example of the washout processor according to the embodiment of the present invention.
Fig. 7 is a schematic plan view showing the second example of the washout processor according to the embodiment of the present invention.
Fig. 8 is a schematic side view showing a third example of the washout processor according to the embodiment of the present invention.
Fig. 9 is a schematic plan view showing the third example of the washout processor according to the embodiment of the present invention.
Fig. 10 is a schematic side view showing a fourth example of the washout processor according to the embodiment of the present invention.
Fig. 11 is a schematic perspective view showing main portions of the fourth example of the washout processor according to the embodiment of the present invention.
Fig. 12 is a schematic plan view showing the main portions of the fourth example of the washout processor according to the embodiment of the present invention.
Fig. 13 is a schematic plan view showing the fourth example of the washout processor according to the embodiment of the present invention.
Fig. 14 is a schematic view showing an evaluation device using examples of the present invention.

### DESCRIPTION OF THE PREFERRED EMBODIMENTS

Hereinafter, a regeneration treatment apparatus, a washout processor, and a manufacturing method of a flexographic printing plate according to an embodiment of the present invention will be described in detail based on suitable embodiments shown in the attached drawings.

The drawings to be described below are exemplary for describing the present invention, and the present invention is not limited to the drawings shown below.

In the following, "to" indicating a numerical range includes numerical values described on both sides. For example, in a case where ε is a numerical value α to a numerical value β, the range ε is a range including the numerical value α and the numerical value β, which is expressed by a mathematical symbol α ≤ ε ≤ β.

Angles such as "perpendicular" and "parallel" include a range of errors generally acceptable in the corresponding technical field unless particularly stated otherwise.

### (Treatment System)

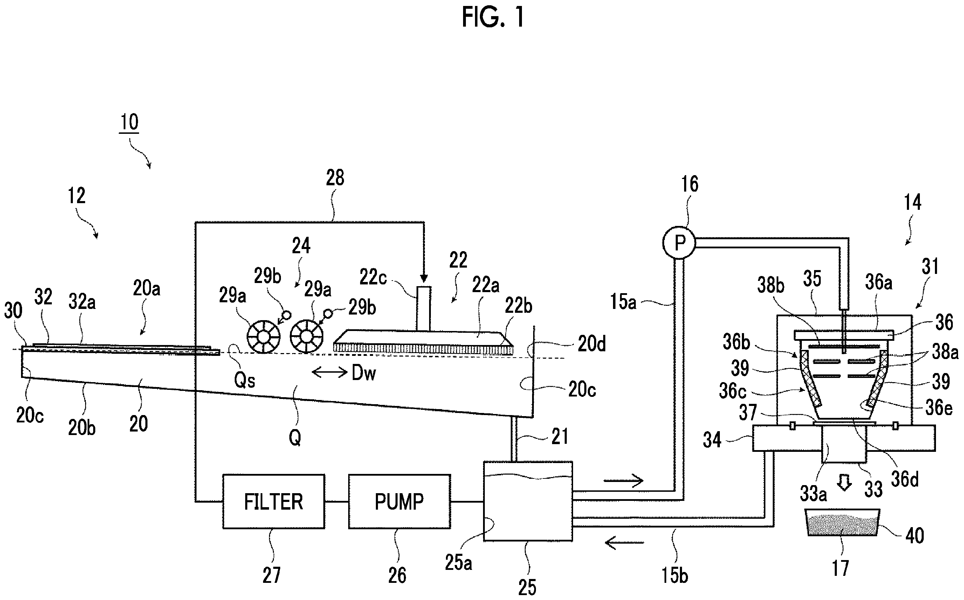

Fig. 1 is a schematic view showing an example of the treatment system having the washout processor and the regeneration treatment apparatus according to the embodiment of the present invention.

A treatment system 10 shown in Fig. 1 has a washout processor 12 and a regeneration treatment apparatus 14, and the regeneration treatment apparatus 14 is connected to the washout processor 12. In the treatment system 10, each of the washout processor 12 and the regeneration treatment apparatus 14 is controlled by a control unit (not shown).

Although the treatment system 10 is configured such that the regeneration treatment apparatus 14 is connected to the washout processor 12, the washout processor 12 is configured to have the regeneration treatment apparatus 14.

The washout processor 12 is an apparatus that develops an imagewise exposed flexographic printing plate precursor 32 having a photosensitive resin layer (not shown) using a washing solution of which a main component is water.

The regeneration treatment apparatus 14 is an apparatus that removes a resin aggregate (not shown) from a used washing solution containing the resin aggregate generated as a non-exposed portion (not shown) of the imagewise exposed flexographic printing plate precursor 32 is removed through development using the washing solution.

In the treatment system 10, for example, a resin aggregate is generated as a non-exposed portion of an imagewise exposed flexographic printing plate precursor having a photosensitive resin layer is removed by the washout processor 12 through development using a washing solution. Regarding this, in a case where there are many non-exposed portions of the flexographic printing plate precursor, a concentration of solid contents in the washing solution increases, and the resin aggregate is generated in the washing solution.

A used washing solution containing a resin aggregate is stored in a tank 25 via a pipe 21. The used washing solution described above stored in the tank 25 is supplied to the regeneration treatment apparatus 14, and the resin aggregate is removed from the used washing solution, obtaining a regenerated washing solution. The used washing solution is also referred to as a fatiqued developer.

Hereinafter, the washout processor 12 and the regeneration treatment apparatus 14 will be described.

### (First Example of Washout Processor)

The washout processor 12 shown in Fig. 1 has a developing tank 20, a developing brush 22, and a rinsing unit 24.

The pipe 21 is provided at a lower surface 20b of the developing tank 20. The tank 25 is connected to the pipe 21. A pump 26 and a filter 27 are provided at the tank 25 in this order.

A pipe 28 is provided at the filter 27, and an opening of the pipe 28 is disposed above the developing brush 22. Accordingly, a washing solution Q can be supplied to the developing brush 22.

The developing brush 22 is obtained, for example, by bundling bristles 22b perpendicular to a circular substrate 22a in plan view. The shape of the substrate 22a is the shape of the developing brush 22. The shape of the substrate 22a is not limited to a circle in plan view.

The developing brush 22 is rotated about a rotation shaft 22c by a driving unit (not shown). In addition, during development, the washing solution Q or a regenerated washing solution is supplied to the developing brush 22 via the rotation shaft 22c. The washing solution Q or the regenerated washing solution is supplied from the developing brush 22 to a plate surface 32a of the flexographic printing plate precursor 32. The developing brush 22 is not limited to being rotationally moved and may perform a combination of linear reciprocation and circular movement.

The developing brush 22 is not limited to one, and for example, a plurality of developing brushes may be disposed.

In addition, a material for the bristles 22b of the developing brush 22 is not particularly limited, and for example, a known material used for the development of the flexographic printing plate precursor 32, such as nylon 6,6, nylon 610, nylon 612, polybutylene terephthalate (PBT), and polyethylene terephthalate (PET), can be used as appropriate. As the material for the bristles of the developing brush 22, a material that has a low water absorption rate and that can suppress a decrease in an elastic modulus during a humid day like nylon 612 is preferable since a development time of the flexographic printing plate precursor 32 can be shortened. The development time is a time until a floor thickness of the flexographic printing plate precursor 32 becomes a set thickness.

The rinsing unit 24 has a brush 29a and a supply port 29b through which a rinsing liquid is supplied to the brush 29a.

The brush 29a is for removing development residues remaining on the plate surface 32a of the developed flexographic printing plate precursor 32, and for example, a rotating brush is used. The development residues are, for example, non-exposed portions or the like.

It is preferable that as bristles of the rotating brush, instead of uncurled bristles, wavy bristles which are called curly bristles or curled bristles, are used rather than straight bristles. In a case where bristles obtained by adding a fine abrasive material such as alumina and silicon carbide to a nylon thread, as a material for the bristles of the rotating brush, are used, abrasion of the brush can also be reduced, and a brush life can be extended, which is preferable.

A supply unit (not shown) for supplying the rinsing liquid is connected to the supply port 29b. Accordingly, for example, water is supplied from the supply port 29b to the brush 29a as the rinsing liquid.

The rinsing unit 24 may be configured to have a liquid drain nozzle (not shown) that removes the rinsing liquid supplied to the flexographic printing plate precursor 32 by jetting a gas or that removes the rinsing liquid by sucking a gas.

The tank 25 stores a used washing solution containing a resin aggregate after development and stores a used washing solution from which a resin aggregate is removed by the regeneration treatment apparatus 14, that is, a regenerated washing solution.

The pump 26 supplies the used washing solution or the regenerated washing solution in the tank 25 to the filter 27 and supplies the used washing solution or the regenerated washing solution to the developing brush 22 via the filter 27 through the pipe 28. The pump 26 is a supply unit that supplies the used washing solution or the regenerated washing solution to the developing tank 20 and functions as a circulation pump. A pump that transfers a known liquid is usable as appropriate as the pump 26.

The filter 27 is a filter that removes solid contents (not shown) and a resin aggregate generated by development from the washing solution Q and removes the solid contents and the resin aggregate in the washing solution after development. The filter 27 can reduce the concentration of the solid contents and the resin aggregate.

The filter 27 is not particularly limited insofar as the solid contents and the resin aggregate in the washing solution after development can be separated out and is determined as appropriate according to the sizes of the solid contents and the resin aggregate to be separated out. For example, a ceramic filter is used. It is preferable that the filter 27 can separate out, for example, a solid content having a particle diameter of 1 µm or less.

The concentration of the solid contents and the resin aggregate in the regenerated washing solution is further decreased by the filter 27 or a filter 59 to be described later.

The imagewise exposed flexographic printing plate precursor 32 is developed in the developing tank 20. The developing brush 22 is disposed on an opening 20a side in the developing tank 20. On a lower surface 20b side of the developing tank 20, a support plate 30 is provided to face the developing brush 22. The flexographic printing plate precursor 32 may be developed in a state of being immersed in the washing solution Q in the developing tank 20 or may be developed while the washing solution Q is supplied to the flexographic printing plate precursor 32.

The imagewise exposed flexographic printing plate precursor 32 is disposed at the support plate 30. The flexographic printing plate precursor 32 is, for example, quadrangular in plan view.

The flexographic printing plate precursor 32 is linearly reciprocated in a direction Dw by a moving mechanism (not shown). For example, the flexographic printing plate precursor is moved below the developing brush 22, is developed, and is moved to an opposite side of the developing brush 22 after development. In this case, residues on the plate surface 32a of the flexographic printing plate precursor 32 are removed by the rinsing unit 24.

The moving mechanism can also adjust the speed of linear reciprocation of the flexographic printing plate precursor 32, that is, a moving speed in the direction Dw. The moving speed in the direction Dw described above, a set distance described above, a total reciprocating distance, the number of times of reciprocation in linear reciprocation are not particularly limited and are determined as appropriate depending on development of the flexographic printing plate precursor 32.

The tank 25 is connected to the regeneration treatment apparatus 14 by a pipe 15a. In addition, the regeneration treatment apparatus 14 and the tank 25 are connected to each other by a pipe 15b. A pump 16 for supplying a used washing solution in the tank 25 to the regeneration treatment apparatus 14 is provided at the pipe 15a.

In the washout processor 12, a resin aggregate comes into contact with a wall surface of an induction path 33 through which the resin aggregate is centrifuged and discharged by free fall. A portion of the induction path with which the resin aggregate can come into contact is composed of polyethylene having a critical surface tension of 31 mN/m or less and a dynamic friction coefficient of 0.2 or less or an average molecular weight of 750,000 to 6,000,000. Accordingly, in a case where the resin aggregate has come into contact, the resin aggregate is unlikely to be attached, contamination is prevented, and the frequency of cleaning also decreases. In addition, even in a case where the resin aggregate is dried, fixing of the resin aggregate is suppressed, and blockage caused by the resin aggregate is also suppressed. Even in a case where the resin aggregate is attached, cleaning can be easily performed. A work load caused by cleaning is reduced, and the frequency of cleaning can be decreased. Accordingly, a time for which development is stopped can be shortened, and production efficiency of development of the flexographic printing plate precursor can be improved.

A critical surface tension is a value measured based on "Japanese Industrial Standards (JIS) K6768 Plastics - Film and sheeting - Determination of wetting tension".

The critical surface tension is a tension at which a solid surface can be completely wet. That is, the critical surface tension is a liquid surface tension at which a contact angle is zero, but can be determined through a wetting tension test (according to JIS K6768) using a commercially available mixed solution for wetting surface tension test. The critical surface tension can be measured, for example, using a mixed solution for wetting surface tension test manufactured by FUJIFILM Wako Pure Chemical Corporation.

Specifically, a mixed solution for test is added dropwise onto a test piece, and immediately the mixed solution for test is spread using a wire bar, a cotton swab, or a brush. A liquid amount which is enough to form a thin layer without creating accumulation is set. Determination is made in a state of a central portion of the liquid film immediately before a timing of moment when two seconds have elapsed after reagents are coated. In a case where the original state is maintained without occurrence of breakage, it is determined that the coated liquid film is "wet", and in a case where breakage has occurred, it is determined that the coated liquid film is "not wet". This operation is repeated at least three times, and a mixed solution that can make the surface of the test piece wet for accurately two seconds is selected. The surface tension of the selected mixed solution is a wetting tension of a solid. For example, a surface tension (critical surface tension) in a case where a reagent that is determined to be "wet" with a 31.0 mN/m mixed solution for wetting tension test (reagent) or that has a different surface tension is added dropwise to measure a contact angle, the surface tension of the reagent versus a contact angle (cosθ) is plotted, and an approximate straight line is extrapolated to cosθ = 1 (zero contact angle) is 31 mN/m or less. Herein, θ indicates the contact angle. The contact angle can be measured using a commercially available device such as a contact angle meter of Kyowa Interface Science Co., Ltd. A known Zisman critical surface tension is shown through a measuring method in which a surface tension in a case where a reagent that has a different surface tension is added dropwise to measure a contact angle, the surface tension of the reagent versus a contact angle (cosθ) is plotted, and an approximate straight line is extrapolated to cosθ = 1 (zero contact angle) is used as a critical surface tension, and which is a method called the Zisman plot. An environment in a case of measuring a critical surface tension is a normal temperature (20°C to 25°C).

A dynamic friction coefficient is a value measured based on "JIS K7125 Plastics - Film and sheeting Determination of the coefficient of friction".

The dynamic friction coefficient is measured by assembling a test device formed of a tension-tester (Autograph of Shimadzu Corporation) (according to JIS K7125) and using an induction path made of stainless steel is measured using an assumed stainless steel plate (a Steel Use Stainless (SUS) 304 plate as a mating material) on a test table. An environment in a case of measuring a dynamic friction coefficient is a normal temperature (20°C to 25°C).

It is found that a resin aggregate is likely to be attached and firmly attached in a case of a material having a critical surface tension exceeding 31 mN/m and a dynamic friction coefficient exceeding 0.2. In addition, for example, it is conceived that in a case where the resin aggregate is attached to a metal, a metal surface is covered with a metal oxide, the oxide reacts to water and becomes a hydroxide layer, and an organic matter configuring the hydroxide layer and the resin aggregate are bonded to each other and becomes a firm attachment.

Herein, contact of the resin aggregate includes not only contact of the resin aggregate alone but also contact of the washing solution in a state where the resin aggregate is contained in the washing solution.

In addition, an average molecular weight is a value based on ASTM International D4020.

A critical surface tension is a surface tension in a case where a contact angle is zero. In a case where the critical surface tension is 31 mN/m or less, a resin aggregate is easily peeled off even in a case of being attached. In a case where the critical surface tension exceeds 31 mN/m, the resin aggregate is easily deposited while being attached.

In addition, the critical surface tension has a lower limit value of 18 mN/m and is preferably 18 to 31 mN/m.

In a case where a dynamic friction coefficient exceeds 0.2, since the resin aggregate attached to an inner portion 33a of the induction path 33 is unlikely to be slid off, attaching and drying of the resin aggregate are repeated, and a large aggregate is formed in a portion in contact with the resin aggregate once or repeatedly, and the induction path 33 is easily blocked.

A portion in contact with a resin aggregate is composed of, for example, at least one selected from groups consisting of perfluoroalkoxy alkane (PFA), polytetrafluoroethylene (PTFE), and polyethylene having an average molecular weight of 700,000 or more.

An upper limit of the average molecular weight of polyethylene is 6,000,000, and the average molecular weight is preferably 1 million to 4 million. In a case where the average molecular weight of polyethylene exceeds 6,000,000, the tensile yield point elongation of a material significantly decreases, the material is easily broken during processing, and impact occurred during an apparatus operation is weak, which is not preferable.

Polyethylene having an average molecular weight of 750,000 to 6,000,000 has a low critical surface tension and a low dynamic friction coefficient and is further excellent in an abrasion resistance. For this reason, as a portion in contact with a resin aggregate is formed of polyethylene having an average molecular weight of 750,000 to 6,000,000, for example, in a case where the resin aggregate is attached, damage to the rubbed location can be suppressed even after a scraper or the like rubs the portion in order to peel off the resin aggregate.

For example, HI-ZEX MILLION (registered trademark) is used as polyethylene having an average molecular weight of 750,000 to 6,000,000.

Ultra high molecular weight polyethylene having an average molecular weight of 1 million to 3.4 million, with which a higher tensile yield point elongation and a higher impact strength are obtained, is processed into a sheet shape or a tape shape and is suitably used by being flexibly adhered along the shape of the induction path through which the resin aggregate is discharged, which is more preferable.

### <Ultra High Molecular Weight Polyethylene>

For example, ultra high molecular weight polyethylene has a density of 0.949 at an average molecular weight of 0.5 million, has a density of 0.940 at an average molecular weight of 1.1 million, has a density of 0.938 at an average molecular weight of 2 million, has a density of 0.934 at an average molecular weight of 3.3 million, and has a density of 0.929 at an average molecular weight of 5.8 million. It is known that ultra high molecular weight polyethylene having a lower density, that is, ultra high molecular weight polyethylene having a larger average molecular weight shows properties that the resin aggregate is difficult to be fixed and is easily peeled off.

A portion in contact with a resin aggregate is a portion in contact with the resin aggregate once or repeatedly. The portion in contact with the resin aggregate also includes, for example, a portion that comes into contact with a liquid splash. Like an inner wall surface of the developing tank 20 and an inner wall 25a of the tank 25, the portion in contact with the resin aggregate repeatedly is also included. In a case where the resin aggregate repeatedly comes into contact, contact and drying of the resin aggregate are repeated, and the resin aggregate is easily fixed. For this reason, in order to suppress the fixing, it is important that the critical surface tension is 31 mN/m or less and the dynamic friction coefficient is 0.2 or less as described above or it is important to form the portion of polyethylene having an average molecular weight of 750,000 to 6,000,000.

A portion in contact with a resin aggregate is specifically, for example, a gas-liquid interface of the washing solution Q at the inner wall surface of the developing tank 20. That is, a liquid level Qs of the washing solution Q is a portion 20d that is in contact with the developing tank 20. In this case, since the resin aggregate caused by solid contents generated by development is difficult to be fixed, a cleaning load of the developing tank can be reduced.

The pipe 21 is also a portion through which a used washing solution passes and with which the resin aggregate comes into contact. In addition, the used washing solution is stored in the tank 25, but the inner wall 25a of the tank 25 is also the portion in contact with the resin aggregate. Since the resin aggregate caused by the solid contents generated by development is difficult to be fixed also to the inner wall 25a of the tank 25, the cleaning load of the developing tank can be reduced.

The portion in contact with the resin aggregate is not limited to the entire portion in contact with the resin aggregate and may be a part with which the resin aggregate comes into contact.

The portion in contact with the resin aggregate may have a configuration integrated with the developing tank 20, the pipe 21, or the tank 25 or may have a separate configuration. In a case of the separate configuration, for example, a configuration of being adhered in a form of a sheet or a tape may be adopted.

### (First Example of Regeneration Treatment Apparatus)

The regeneration treatment apparatus 14 removes a resin aggregate from a used washing solution containing the resin aggregate, for example, using centrifugation. The regeneration treatment apparatus 14 has a centrifuge 31 and the induction path 33 through which the resin aggregate from the centrifuge 31 passes through the inner portion 33a.

The regeneration treatment apparatus 14 has a base 34, a case 35, a rotating body 36, a shutter 37, and a collection container 40. In addition, although not shown, a driving unit (not shown) such as a motor that rotates the rotating body 36 is provided. The rotating body 36 is rotated by the driving unit.

The case 35 covers the rotating body 36, and the used washing solution overflowing from an opening portion 36a of the rotating body 36 accumulates in the base 34. The base 34 is provided at the pipe 15b. The used washing solution overflowing from the opening portion 36a of the rotating body 36 accumulates in the base 34, moves to the tank 25 via the pipe 15b, and is stored therein. In the washout processor 12, the used washing solution from which the resin aggregate is removed using the regeneration treatment apparatus 14 can also be used, and the flexographic printing plate precursor 32 can also be developed using the used washing solution.

The resin aggregate is removed from the used washing solution overflowing from the opening portion 36a of the rotating body 36.

The rotating body 36 stores a used washing solution and is formed by integrating a cylindrical trunk portion 36b and a conical base-shaped inclined part 36c with each other. A bottom portion 36d of the rotating body 36 on a base 34 side is opened and is blocked by the shutter 37. In the rotating body 36, a side where there is the trunk portion 36b is an upper side, and a side where there is the inclined part 36c is a lower side.

Inside the rotating body 36, a plurality of inside disks 38a are disposed to be spaced apart from each other and to overlap each other. A separation plate 38b is disposed at an upper portion of the rotating body 36. The inside disks 38a are disposed with gaps with respect to an inner surface of the rotating body 36. A scraper 39 is provided at the gap.

The inside disks 38a retain a resin aggregate contained in a used washing solution, which is accumulated through centrifugation, in the rotating body 36.

Both the inside disks 38a and the separation plate 38b are fixed into the rotating body 36 and are configured to rotate together with the rotating body 36 in a case where the rotating body 36 rotates, but are not limited thereto. A state where the inside disks 38a are provided with respect to the rotating body 36 is not particularly limited insofar as a centrifugal force can be applied to the resin aggregate held by the inside disks 38a in a case where the rotating body 36 is rotated.

The inside disks 38a are not limited to being provided in plurality, and at least one may be provided.

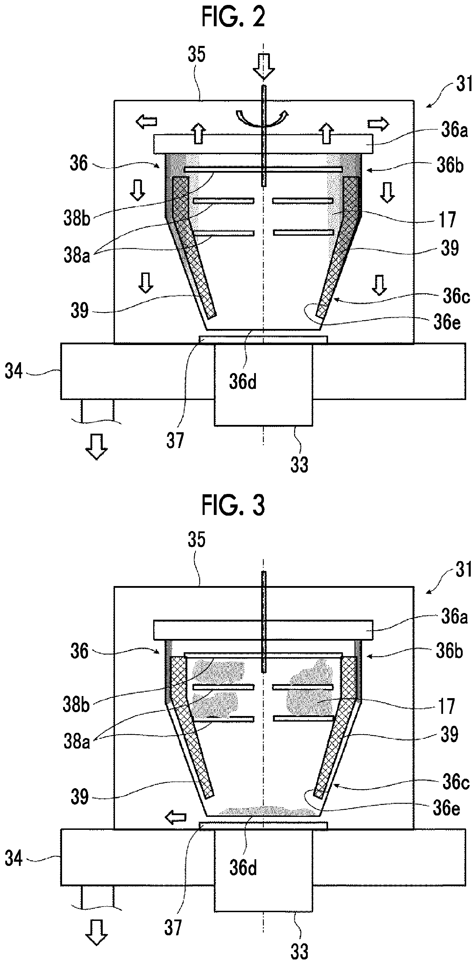

The separation plate 38b induces a liquid having a heavy specific gravity (aggregation separation liquid) pressed against an inner wall 36e of the rotating body 36 during rotation from an inner wall 36e side to the opening portion 36a of the rotating body 36. The separation plate 38b is provided in order to separate the liquid having a heavy specific gravity on the inner wall 36e side during rotation in Fig. 2 from a light liquid close to a rotation center and not to discharge a light aggregate at an interface during rotation from the opening portion 36a of the rotating body 36.

The scraper 39 scrapes and removes a deposit deposited on the inner wall 36e of the rotating body 36. A resin aggregate deposited on the inner wall 36e is removed by the scraper 39.

The scraper 39 is composed of, for example, a flat plate movable along the inner wall 36e. The scraper 39 is in a state of being fixed into the rotating body 36 during centrifugation and rotates in the same direction and at the same speed as those of the rotating body 36. In a case of removal, the scraper 39 is rotated by a movement portion (not shown) in a direction opposite to a direction in which the rotating body 36 rotates.

The centrifuge 31 has a configuration that has the rotating body 36, the inside disks 38a, the separation plate 38b, the scraper 39, and a motor (not shown).

The shutter 37 is provided at the bottom portion 36d of the rotating body 36 on the base 34 side. The shutter 37 is openable and closable. In a state where the shutter 37 is closed, the rotating body 36 and the induction path 33 do not communicate with each other. On the other hand, in a state where the shutter 37 is opened, the rotating body 36 and the induction path 33 communicate with each other, and a resin aggregate in the rotating body 36 is discharged to the inner portion 33a of the induction path 33. A resin aggregate 17 is collected by the collection container 40 disposed below the induction path 33.

A portion of the regeneration treatment apparatus 14 with which the resin aggregate can come into contact is composed of polyethylene having a critical surface tension of 31 mN/m or less and a dynamic friction coefficient of 0.2 or less or an average molecular weight of 750,000 to 6,000,000. Accordingly, in a case where the resin aggregate has come into contact, the resin aggregate is unlikely to be attached, contamination is prevented, and the frequency of cleaning also decreases. In addition, even in a case where the resin aggregate is dried, fixing is suppressed, and blockage caused by the resin aggregate is also suppressed. Even in a case where the resin aggregate is attached, cleaning can be easily performed. A work load caused by cleaning is reduced, and the frequency of cleaning can be decreased. Accordingly, a time for which development is stopped can be shortened, and production efficiency of development of the flexographic printing plate precursor can be improved.

A portion in contact with the resin aggregate is composed of, for example, at least one selected from groups consisting of perfluoroalkoxy alkane, polytetrafluoroethylene, and polyethylene having an average molecular weight of 700,000 or more.

For example, in a case where the resin aggregate is stuck and rubbed with the scraper or the like, these are damaged. However, in a case where the portion in contact with the resin aggregate is formed of, for example, polyethylene having an average molecular weight of 750,000 to 6,000,000, an abrasion resistance is also excellent, which is more preferable.

As described above, ultra high molecular weight polyethylene having an average molecular weight of 1 million to 3.4 million, with which a higher tensile yield point elongation and a higher impact strength are obtained, is processed into a sheet shape or a tape shape and is suitably used by being flexibly adhered along the shape of the induction path through which the resin aggregate is discharged, which is more preferable.

A portion in contact with the resin aggregate is the portion in contact with the resin aggregate once or repeatedly also in the regeneration treatment apparatus 14. The portion in contact with the resin aggregate also includes, for example, a portion that comes into contact with a liquid splash.

It is not necessary to form the entire portion of the regeneration treatment apparatus 14 with which the resin aggregate comes into contact of polyethylene having a critical surface tension of 31 mN/m or less and a dynamic friction coefficient of 0.2 or less or an average molecular weight of 750,000 to 6,000,000, but may be partially used in a portion where the resin aggregate falls due to its own weight or flows through an inclined surface or a portion having a possibility of a liquid being scattered and attached to a portion where it is not originally necessary for the resin aggregate to be attached during an operation. The resin aggregate is difficult to be fixed to a portion where the resin aggregate flows at all times due to application of an external force since the resin aggregate in constant contact with a member surface is replaced. However, liquid droplets having a low flow rate as in dead weight fall or containing the scattered resin aggregate are easily fixed. In addition, sludge containing the resin aggregate is difficult to be dried under a closed condition in which there is no direct exposure to outside air, but the resin aggregate is easily dried and is easily fixed under a condition in which outside air is allowed to enter and exit. It is more effective to apply polyethylene having a critical surface tension of 31 mN/m or less and a dynamic friction coefficient of 0.2 or less or an average molecular weight of 750,000 to 6,000,000 to such a portion.

The portion in contact with the resin aggregate is, for example, the induction path 33, and is particularly the inner portion 33a of the induction path 33 through which the resin aggregate passes. The portion in contact with the resin aggregate may have a configuration integrated with the induction path 33 or may have a separate configuration. In a case of the separate configuration, for example, a configuration of being adhered in a form of a sheet or a tape may be adopted.

### (First Example of Regeneration Treatment Method)

Figs. 2 to 5 are schematic views showing a treatment method using the regeneration treatment apparatus according to the embodiment of the present invention in the order of steps. In Figs. 2 to 5, the same configuration components as in the treatment system 10 shown in Fig. 1 will be assigned with the same reference numerals, and detailed description thereof will be omitted.

In a state where the rotating body 36 of the centrifuge 31 shown in Fig. 2 is rotated by the driving unit (not shown), a used washing solution containing the resin aggregate is supplied from the tank 25 shown in Fig. 1 into the rotating body 36 of the centrifuge 31 shown in Fig. 2 through the pipe 15a by the pump 16.

In this case, the used washing solution and the resin aggregate supplied to the rotating body 36 are separated from each other, and the used washing solution from which the resin aggregate is removed is separated from the resin aggregate having a low specific gravity by the separation plate 38b, overflows from the opening portion 36a of the rotating body 36 through the pipe 15b via the base 34, and moves to the tank 25.

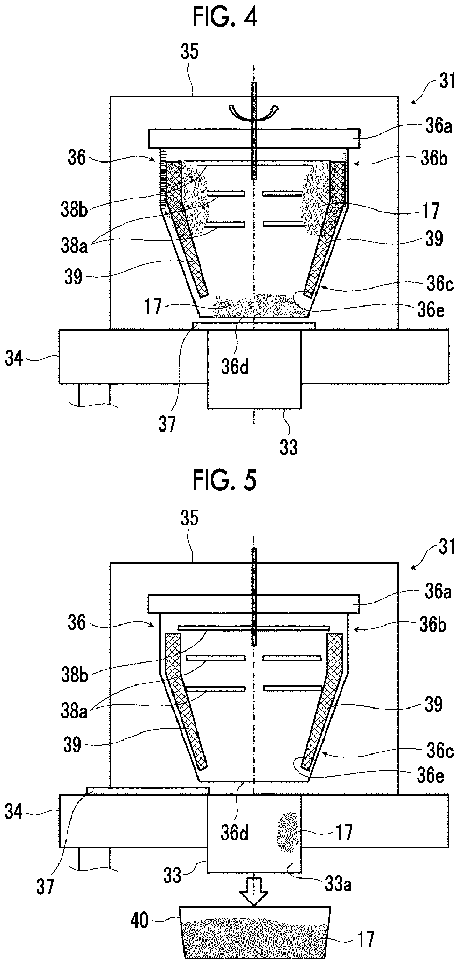

The resin aggregate 17 having a specific gravity lower than that of the washing solution accumulates at a central portion on the inside disk 38a through centrifugation. Next, supply of the used washing solution containing the resin aggregate is stopped, and rotation of the rotating body 36 is also stopped. Accordingly, as shown in Fig. 3, the resin aggregate 17 accumulates on the inside disks 38a, and the resin aggregate 17 is deposited on a bottom portion of the rotating body 36. In this case, the used washing solution from which the resin aggregate 17 is removed is discharged from the bottom portion 36d and moves to the tank 25 via the base 34 and the pipe 15b. The rotating body 36 is rotated again. Accordingly, the resin aggregate 17 moves from above the inside disks 38a, and the resin aggregate 17 is deposited on the inner wall 36e of the rotating body 36 as shown in Fig. 4.

Next, as shown in Fig. 5, the shutter 37 is opened. Next, the scraper 39 is rotated. Accordingly, the resin aggregate 17 inside the rotating body 36 passes through the inner portion 33a of the induction path 33 and is discharged to the outside. In a case of discharging the resin aggregate 17 inside the rotating body 36 to the outside, air may be jetted into the rotating body 36. Accordingly, the resin aggregate 17 is easily discharged to the outside. The resin aggregate is also called sludge.

Insofar as the resin aggregate can be removed from the used washing solution containing the resin aggregate, the regeneration treatment apparatus 14 is not particularly limited to a configuration of including the centrifuge 31 and the induction path 33 as shown in Fig. 1. For example, the regeneration treatment apparatus may be configured to have a filter that removes the resin aggregate from the used washing solution containing the resin aggregate and an induction path that induces the used washing solution which has passed through the filter.

### <Washing Method>

Next, a washing method will be described. The washing method is a developing method, and washing is development. Through washing, the flexographic printing plate precursor 32 is developed, obtaining a flexographic printing plate. For this reason, the washing method corresponds to the manufacturing method of a flexographic printing plate. Similarly, the washing method described below corresponds to the manufacturing method of a flexographic printing plate.

The flexographic printing plate precursor 32 (see Fig. 1) is imagewise exposed in a specific pattern or the like by an exposure device (not shown).

Next, as shown in Fig. 1, the imagewise exposed flexographic printing plate precursor 32 is attached to the support plate 30.

Next, the flexographic printing plate precursor 32 is transported below the developing brush 22, and the bristles 22b of the developing brush 22 are brought into contact with an image forming surface of the flexographic printing plate precursor 32, that is, the plate surface 32a of the flexographic printing plate precursor 32.

Next, the washing solution Q is supplied to the developing brush 22 through the pipe 28 via the filter 27 by the pump 26.

Next, the developing brush 22 is rotated, and the imagewise exposed flexographic printing plate precursor 32 is rubbed with the developing brush 22 and is developed.

After development, the developed flexographic printing plate precursor 32 is transported to be separated from the developing brush 22, and the developed flexographic printing plate precursor is carried out from the developing tank 20. In this case, residues such as latex components and rubber components remaining on the plate surface 32a of the flexographic printing plate precursor 32 are removed by the brush 29a of the rinsing unit 24.

In a developing step, in order to promote development, for example, the temperature of the washing solution Q is adjusted at a constant temperature in a range of 40°C to 50°C by a heater, and the temperature of the washing solution Q is preferably kept in a state suitable for development.

The used washing solution Q used in development returns from the lower surface 20b of the developing tank 20 to the tank 25 via the pipe 21. For example, the used washing solution Q in the tank 25 is sent to the regeneration treatment apparatus 14 by the pump 16 as described above. The resin aggregate is removed and is returned into the tank 25. The used washing solution Q passes through the pipe 28 via the filter 27 by the pump 26 and is supplied to the developing brush 22. The flexographic printing plate precursor 32 is developed using the used washing solution Q from which the resin aggregate is removed.

In the washing method, the used washing solution from which the resin aggregate is removed using the regeneration treatment apparatus 14 as described above is also used.

In the washing method, a timing when the resin aggregate is removed by the regeneration treatment apparatus 14 is, for example, a case where the concentration of solid contents of the washing solution Q in the tank 25 exceeds a set concentration or a case where a treatment area of the flexographic printing plate precursor 32 exceeds a set treatment area. The used washing solution in the tank 25 is supplied to the rotating body 36 of the regeneration treatment apparatus 14 by the pump 16, as in the first example of the regeneration treatment method described above, the resin aggregate is removed from the used washing solution, and the used washing solution from which the resin aggregate is removed is transferred to the tank 25 through the pipe 15b.

### (Second Example of Washout Processor)

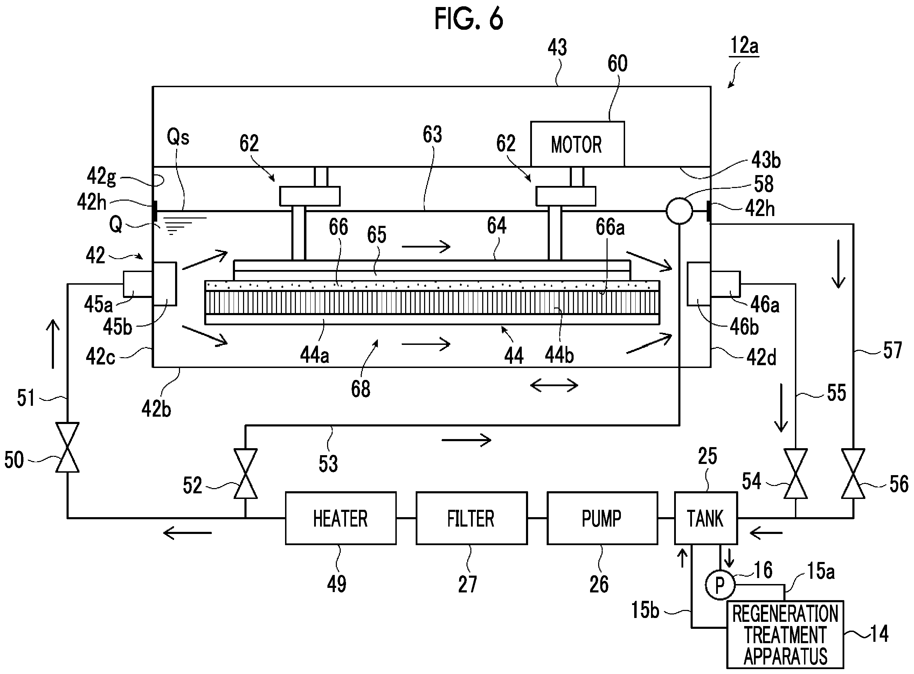

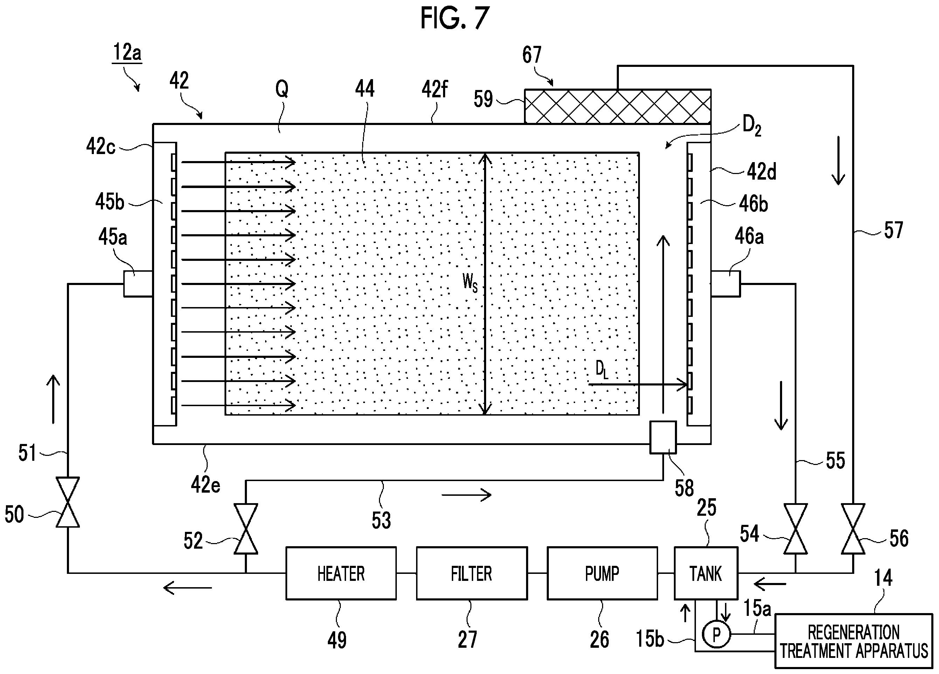

Fig. 6 is a schematic side view showing a second example of the washout processor according to the embodiment of the present invention. Fig. 7 is a schematic plan view showing the second example of the washout processor according to the embodiment of the present invention. A washout processor 12a shown in Fig. 6 has a configuration called a clamshell type. In Fig. 7, a lid 43 is not shown. In addition, a control unit is not shown in Figs. 6 and 7, but each unit of the washout processor 12a is controlled by the control unit.

The washout processor 12a has a developing tank 42 and the lid 43 of the developing tank 42. The lid 43 is openable and closable with respect to the developing tank 42, and for example, the developing tank 42 and the lid 43 are connected to each other using a hinge. In a state where the lid 43 is closed as shown in Fig. 6, a back surface 43b of the lid 43 faces the liquid level Qs of the washing solution Q in the developing tank 42.

A brush 44 is disposed on a bottom surface 42b side in the developing tank 42. In a state where the brush 44 is fixed, development is performed on the flexographic printing plate precursor 32. The brush 44 is obtained, for example, by bundling bristles 44b perpendicular to a quadrangular substrate 44a in plan view. The substrate 44a is fixed into the developing tank 42 by a fixing unit (not shown). The shape of the substrate 44a is the shape of the brush 44. The shape of the substrate 44a is not limited to a quadrangle in plan view.

In addition, a material for the bristles of the brush 44 is not particularly limited, and for example, a known material used for the development of the flexographic printing plate precursor 32, such as nylon 6,6, nylon 610, nylon 612, polybutylene terephthalate (PBT), and polyethylene terephthalate (PET), can be used as appropriate.

A supply port 45a is provided in a side surface 42c of the developing tank 42. A blowout port 45b is provided at the supply port 45a in the developing tank 42. A first valve 50 is provided at the supply port 45a via a pipe 51.

An output port 46a is provided in a side surface 42d facing the side surface 42c of the developing tank 42. A suction port 46b is provided at the output port 46a in the developing tank 42. A third valve 54 is provided at the output port 46a via a pipe 55.

The tank 25, the pump 26, the filter 27, and a heater 49 are provided from a third valve 54 side between the first valve 50 and the third valve 54. The tank 25 is connected to the regeneration treatment apparatus 14.

The washing solution Q in the developing tank 42 is taken in from the output port 46a via the suction port 46b by the pump 26, goes via the filter 27 and the heater 49, and is supplied into the developing tank 42 from the supply port 45a via the blowout port 45b as a regenerated washing solution as will be described later. The pump 26 is a supply unit that supplies the washing solution Q from which a non-exposed portion is removed by the filter 27 to the developing tank 42, and a pump that transfers a known liquid is usable as appropriate. The pump 26 corresponds to the supply unit that supplies the washing solution Q from which the resin aggregate is removed to the developing tank 42.

The filter 27 is a filter that removes solid contents generated by development from the washing solution Q and removes the solid contents in the washing solution after the development. The filter 27 can reduce the concentration of the solid contents. Even with the filter 27, a regenerated washing solution is obtained from the washing solution after the development, that is, a fatiqued developer. For this reason, the regenerated washing solution is supplied to the developing tank 42 through the filter 27.

The filter 27 is not particularly limited insofar as a non-exposed portion or the resin aggregate such as the solid contents in the washing solution after development can be separated out and is determined as appropriate according to the sizes of solid contents to be separated out. For example, a ceramic filter is used. It is preferable that the filter 27 can separate out, for example, a solid content having a particle diameter of 1 µm or less.

The regenerated washing solution is a solution obtained by reducing the concentration of the resin aggregate from the used washing solution with the filter 27 or the filter 59 to be described later.

The heater 49 adjusts the temperature of the washing solution Q supplied into the developing tank 42 to a determined temperature, for example, a range of 40°C to 50°C. A liquid temperature of the washing solution Q is adjusted by the heater 49. The configuration of the heater 49 is not particularly limited, and a known configuration is usable as appropriate.

In addition, a temperature adjusting device (not shown) that has the heater 49 which adjusts the liquid temperature of the washing solution Q may be included, or the temperature adjusting device may be the heater 49.

As shown in Fig. 7, a liquid feeding port 58 is provided in a side surface 42e of the developing tank 42. A second valve 52 is provided at the liquid feeding port 58 via a pipe 53. The second valve 52 is connected between the heater 49 and the first valve 50. The washing solution Q after development is supplied to the liquid feeding port 58 via the filter 27 and the heater 49.

At a side surface 42f facing the side surface 42e, the filter 59 is provided on an overflow port facing the liquid feeding port 58. A port from which a liquid overflowing from the developing tank 42 due to inflow of the washing solution Q to the developing tank 42 is discharged is referred to as the overflow port.

The filter 59 consists of a nonwoven fabric made of a polyolefin-based resin, is spread in the overflow port, and allows an overflowing liquid caused by the inflow of the washing solution Q to the developing tank 42 to pass therethrough. The filter 59 removes a non-exposed portion of the flexographic printing plate precursor 32 which is generated by development from the washing solution Q. A resin component of the flexographic printing plate precursor 32, which is the non-exposed portion, has a low specific gravity and thereby aggregates or floats on the liquid level Qs while diffusing in the washing solution Q. Relatively large floating substances floating on the liquid level Qs are discharged from the overflow port with the inflow of the washing solution Q and are captured by the filter 59.

A fourth valve 56 is provided at the overflow port comprising the filter 59 via a pipe 57. The washing solution Q flows from the liquid feeding port 58 in the developing tank 42 to form a flow of the washing solution Q from the liquid feeding port 58 toward the filter 59.

A region between the liquid feeding port 58 and the filter 59 is a second region D₂ where the flexographic printing plate precursor 32 is carried out.

In the second region D₂, as a flow of the washing solution Q in a direction Fi from the liquid feeding port 58 toward the filter 59 is formed, a non-exposed portion (not shown) removed by development is prevented from being attached to the developed flexographic printing plate precursor 32. That is, solid contents are prevented from being attached to the developed flexographic printing plate precursor 32.

The direction Fi from the liquid feeding port 58 toward the filter 59 is not particularly limited insofar as the direction Fi is an intersecting direction to cross a width Ws of the flexographic printing plate precursor 32, but is preferably a direction orthogonal to a traveling direction D_{L} of the flexographic printing plate precursor 32.

In a case where the term "orthogonal" is defined as 90°, the orthogonal direction described above is allowed to be in a range of 80° to 100°.

In the example shown in Fig. 7, the filter 59 that efficiently removes relatively large floating substances floating on the liquid level Qs and that can reduce a load on the filter 27 is included at the overflow port, but an effect of preventing solid contents from being attached to the developed flexographic printing plate precursor 32 is not impaired even without the filter 59.

A flow creation unit 67 that flows the washing solution Q in the intersecting direction to cross the width Ws of the flexographic printing plate precursor 32 is composed of the pump 26, the filter 27, the heater 49, the filter 59, the second valve 52, and the fourth valve 56.

As shown in Fig. 6, a motor 60 is provided inside the lid 43. For example, two cranks 62 are provided at the back surface 43b of the lid 43. Each of the cranks 62 is connected to a flat plate-shaped fixing member 64. The imagewise exposed flexographic printing plate precursor 32 is fixed to the fixing member 64 using a support plate 65. The support plate 65 is composed of, for example, an adhesive plate.

For example, the exposure device (not shown) imagewise exposes the plate surface 32a of the flexographic printing plate precursor 32. The plate surface 32a of the imagewise exposed flexographic printing plate precursor 32 is a development surface and becomes a printing surface.

In addition, one crank 62 of the two cranks 62 is connected to the motor 60. The two cranks 62 are connected to each other, and in a case where the one crank 62 rotates, the other crank 62 rotates in synchronization with the rotation. For this reason, in a case where the one crank 62 is rotated by the motor 60, the other crank 62 also rotates in synchronization with the rotation. Accordingly, the flexographic printing plate precursor 32 moves eccentrically. For example, a development unit 68 is composed of the motor 60, the cranks 62, the fixing member 64, and the brush 44.

In the washout processor 12a, the brush 44 does not move, but the flexographic printing plate precursor 32 is moved in the washing solution Q such that the image forming surface of the flexographic printing plate precursor 32 moves eccentrically on the brush 44.

In addition, in the washout processor 12a, although not shown, the lid 43 is opened, and the support plate 65 is fixed to the fixing member 64, for example, using a gluing agent. Accordingly, the flexographic printing plate precursor 32 can be fixed to the fixing member 64. In a case of removing the flexographic printing plate precursor 32, the lid 43 is opened, and the support plate 65 is removed from the fixing member 64. In a case of moving and taking out the flexographic printing plate precursor 32 in the traveling direction D_{L}, solid contents are likely to be stuck to the plate surface 32a of the flexographic printing plate precursor 32 on a liquid level Qs side due to the surface tension of the washing solution Q in a case where the solid contents float on the liquid level Qs of the washing solution Q. For this reason, as described above, in the second region D₂, as a flow of the washing solution Q in the direction Fi from the liquid feeding port 58 toward the filter 59 is formed, the solid contents are prevented from being attached to the plate surface 32a of the developed flexographic printing plate precursor 32 by the washing solution Q.

A liquid flow rate of the washing solution Q is preferably 50 cm/sec or more. In a case where the liquid flow rate of the washing solution Q is 50 cm/sec or more, attachment of solid contents or the like to the developed flexographic printing plate precursor 32 can be more reliably prevented, which is preferable. An upper limit of the liquid flow rate of the washing solution Q is not particularly limited, but is 200 cm/sec or less based on pump performance or the like.

The liquid flow rate of the washing solution Q is a minimum speed of the washing solution Q and is, for example, a liquid flow rate at the side surface 42f of the developing tank 42.

The liquid flow rate of the washing solution Q can be measured using a thermal flow meter or the like, and specifically, for example, SI5007 manufactured by ifm efector or the like is used.

In the washout processor 12a, a portion in contact with the resin aggregate is, for example, an inner wall surface 42g of the developing tank 42, particularly the gas-liquid interface of the washing solution Q at the inner wall surface 42g. That is, the liquid level Qs of the washing solution Q is a portion 42h that is in contact with the developing tank 20. In addition, the inner wall 25a of the tank 25 (see Fig. 1) is also the portion in contact with the resin aggregate, as in the washout processor 12 described above.

As described above, the portion in contact with the resin aggregate is composed of polyethylene having a critical surface tension of 31 mN/m or less and a dynamic friction coefficient of 0.2 or less or an average molecular weight of 750,000 to 6,000,000. The portion in contact with the resin aggregate can be configured to have the same composition as that of the washout processor 12 described above.

The portion in contact with the resin aggregate may have a configuration integrated with the developing tank 42 or may have a separate configuration.

### <Washing Method>

A washing method of the washout processor 12a will be described. Through washing as described above, the flexographic printing plate precursor 32 is developed, obtaining a flexographic printing plate.

First, in the washing method, the imagewise exposed flexographic printing plate precursor 32 is attached to the support plate 65, and the support plate 65 is attached to the fixing member 64. The inside of the developing tank 42 is filled with the washing solution Q. Then, the lid 43 is closed. The flexographic printing plate precursor 32 is immersed in the washing solution Q. The image forming surface of the flexographic printing plate precursor 32, that is, the plate surface 32a of the flexographic printing plate precursor 32 is brought into contact with the bristles 44b of the brush 44.

Next, the one crank 62 is rotated by the motor 60, the other crank 62 is also rotated in synchronization with the rotation, the flexographic printing plate precursor 32 is moved eccentrically, and the flexographic printing plate precursor 32 is developed in a state of being immersed in the washing solution Q.

In development, in order to promote development, for example, the temperature of the washing solution Q is adjusted at a constant temperature in a range of 40°C to 50°C by the heater 49, and the washing solution Q is kept in a state of being uniformly circulated in the developing tank 42.

In addition, the washing solution Q that has passed through the filter 27 is supplied from the supply port 45a into the developing tank 42 via the blowout port 45b, the washing solution Q in the developing tank 42 is taken in from the output port 46a via the suction port 46b by the pump 26 and goes via the filter 27 and the heater 49, and the washing solution Q is supplied into the developing tank 42. The washing solution Q is circulated from the side surface 42c toward the side surface 42d of the developing tank 42. Accordingly, a flow of the washing solution Q from the side surface 42c toward the side surface 42d of the developing tank 42 is formed. In addition, in this case, the washing solution Q is flowed parallel to a front surface of the flexographic printing plate precursor 32. In this case, in a state where the first valve 50 and the third valve 54 are open and a state where the second valve 52 and the fourth valve 56 are closed, a circulation path for the washing solution Q is configured.

As described above, as the washing solution Q is flowed from the blowout port 45b, the washing solution Q is taken in from the suction port 46b, and a flow of the washing solution from the side surface 42c toward the side surface 42d of the developing tank 42 is formed, the washing solution Q flowed in from the blowout port 45b simultaneously flows up and down with respect to the brush 44, and deposit of aggregated sediments on an edge part of the brush 44 and sedimentation of an unhardened portion on a bottom portion of the developing tank 42 can be suppressed.

After development, the lid 43 is opened, and the developed flexographic printing plate precursor 32 is taken out from the washing solution Q.

In development treatment, a solid content and a photosensitive resin aggregate of a non-exposed portion scraped off the flexographic printing plate precursor 32 sediment on the edge part of the brush 44 or the bottom portion of the developing tank 42. A resin component, which is the non-exposed portion of the flexographic printing plate precursor 32, has a low specific gravity and thereby aggregates or floats on the liquid level Qs while diffusing in the washing solution Q.

In a case of discharging the flexographic printing plate precursor 32, on which development treatment is performed, to the outside of the washing solution Q, in order to prevent solid contents dispersed or floating in the washing solution Q from being attached to the flexographic printing plate precursor 32, it is found that providing a flow of the washing solution Q in a direction intersecting the traveling direction in which the flexographic printing plate precursor 32 is discharged is effective in preventing attachment of the solid contents, instead of carrying the flexographic printing plate precursor 32 out of the washing solution Q from a state where the washing solution Q flows parallel to the plate surface 32a of the flexographic printing plate precursor 32.

In addition, it is known that solid contents are likely to be attached to the plate surface 32a of the developed flexographic printing plate precursor 32.

In a case of taking out the flexographic printing plate precursor 32 from the washing solution Q, in order to prevent solid contents floating in the washing solution Q from being attached to the flexographic printing plate precursor 32 even in a case where a washing solution circulation state where the solid contents are unlikely to be attached to the flexographic printing plate precursor 32 is kept in the washing solution Q, for example, the flexographic printing plate precursor 32 is moved in the traveling direction D_{L} after development. In a case where the flexographic printing plate precursor 32 is raised from the washing solution Q, a flow of the washing solution Q is formed in the direction intersecting the traveling direction D_{L} of the flexographic printing plate precursor 32 at an interface between the flexographic printing plate precursor 32 and the washing solution Q. In this case, as the first valve 50 and the third valve 54 are closed, the second valve 52 and the fourth valve 56 are opened, and a flow of the washing solution Q in the direction Fi from the liquid feeding port 58 toward the filter 59 is formed in the second region D₂, the floating solid contents flow while riding a liquid flow, so that the solid contents are prevented from being attached to the flexographic printing plate precursor 32. In addition, the solid contents are captured by the filter 59.

In a case of forming the flow of the washing solution Q in the direction Fi described above, the second valve 52 and the fourth valve 56 are opened, and the first valve 50 and the third valve 54 are closed, but the configuration is not limited thereto. In this case, a flow of the washing solution Q from the side surface 42c toward the side surface 42d decreases simply by narrowing the first valve 50 and the third valve 54.

The configuration of the washout processor 12a is not limited to the configuration shown in Fig. 6 and may be other configurations.

In the washing method, a used washing solution from which the resin aggregate is removed using the regeneration treatment apparatus 14 is also used.

In the washing method, a timing when the resin aggregate is removed by the regeneration treatment apparatus 14 is, for example, a case where the concentration of solid contents of the washing solution Q in the tank 25 exceeds a set concentration or a case where a treatment area of the flexographic printing plate precursor 32 exceeds a set treatment area. The used washing solution in the tank 25 is supplied to the rotating body 36 of the regeneration treatment apparatus 14 by the pump 16, as in the first example of the regeneration treatment method described above, the resin aggregate is removed from the used washing solution, and the used washing solution from which the resin aggregate is removed is transferred to the tank 25 through the pipe 15b.

### (Third Example of Washout Processor)

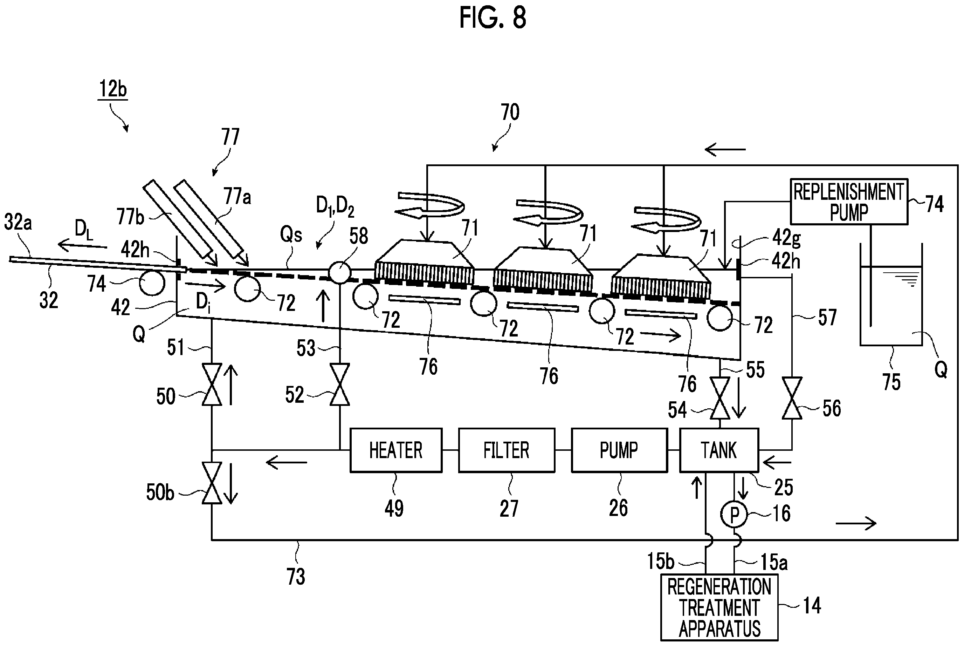

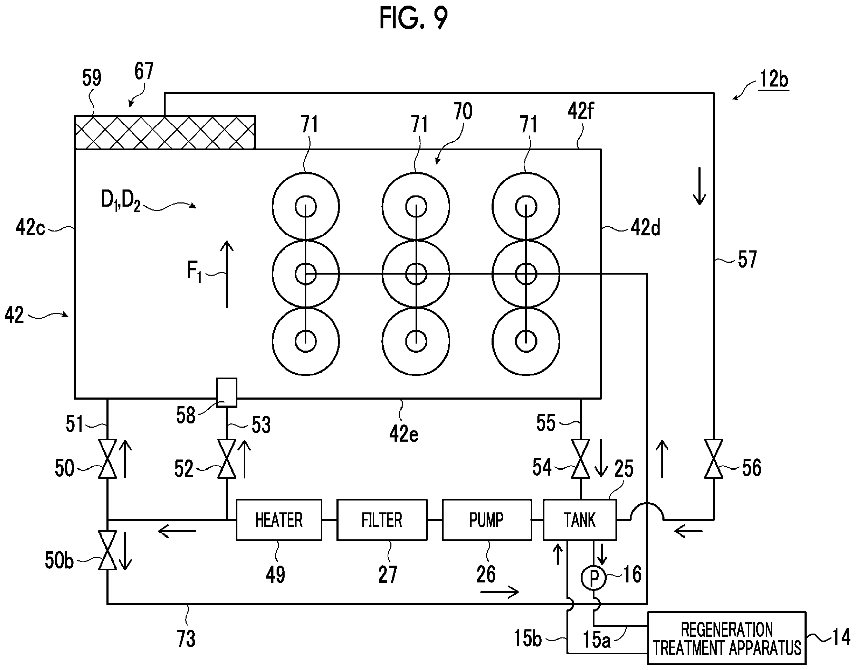

Fig. 8 is a schematic side view showing a third example of the washout processor according to the embodiment of the present invention. Fig. 9 is a schematic plan view showing the third example of the washout processor according to the embodiment of the present invention.

In Figs. 8 and 9, the same components as those of the washout processor 12a shown in Figs. 6 and 7 will be assigned with the same reference numerals, and detailed description thereof will be omitted. In addition, a control unit is not shown in Figs. 8 and 9, but each unit of a washout processor 12b is controlled by the control unit.

The washout processor 12b shown in Fig. 8 has a development unit 70 that removes and develops a non-exposed portion of an imagewise exposed flexographic printing plate precursor using the washing solution Q.

As shown in Fig. 9, the first valve 50 is connected to the side surface 42e of the developing tank 42 via the pipe 51. The second valve 52 is connected to the side surface 42e of the developing tank 42 via the pipe 53. The third valve 54 is connected to the side surface 42e of the developing tank 42 via the pipe 55.

As shown in Fig. 8, the development unit 70 is disposed at the developing tank 42 and has a plurality of brushes 71.

A plurality of transport rollers 72 are provided in the developing tank 42. A support body 76 that supports the flexographic printing plate precursor 32 is provided between the transport rollers 72. Each brush 71 is disposed on each support body 76. For example, as shown in Fig. 9, although the brushes 71 are disposed in three lines with three brushes as a line, the number of brushes 71 and the number of lines are not particularly limited. In addition, a brush shape may be a polygon in addition to a circle, is not particularly limited, and is determined by the configuration of the washout processor 12b as appropriate. The support body 76 shown in Fig. 8 may not be included.

The brush 71 is connected to a connecting pipe 73. The connecting pipe 73 is connected to the tank 25, the pump 26, the filter 27, and the heater 49, and a fifth valve 50b is provided at the connecting pipe 73. The washing solution Q or a regenerated washing solution is supplied to the brushes 71 through the connecting pipe 73. By opening and closing the fifth valve 50b, the supply of the washing solution Q or the regenerated washing solution to the brushes 71 is controlled.

In addition, the tank 25 is connected to the third valve 54 and the fourth valve 56. Further, the tank 25 is connected to the regeneration treatment apparatus 14.

In addition, a base (not shown) on which the flexographic printing plate precursor 32 is placed may be provided adjacent to the developing tank 42. The flexographic printing plate precursor 32 is sent out from the base to the transport rollers 72, and the flexographic printing plate precursor 32 is transported in a carry-in direction Di by the transport rollers 72. In addition, the flexographic printing plate precursor 32 is transported also in an opposite direction to the carry-in direction Di by the transport rollers 72.

A method of carrying in the flexographic printing plate precursor 32 in a state of being fixed to the support plate 65 (see Fig. 6) may be adopted, like the washout processor 12a shown in Fig. 6. In a case of using the support plate 65 (see Fig. 6), the flexographic printing plate precursor 32 is fixed to the support plate 65 such that an imagewise exposure surface is on a brush side.

In the washout processor 12b, the flexographic printing plate precursor 32 is transported to the developing tank 42 along one determined transport path and is carried out from the developing tank 42. The flexographic printing plate precursor 32 carried into the washing solution Q and the flexographic printing plate precursor 32 carried out from the washing solution Q pass through the same region. For this reason, in the washout processor 12b, a first region Di where the flexographic printing plate precursor 32 is carried into the washing solution Q of the developing tank 42 and the second region D₂ where the flexographic printing plate precursor 32 is carried out from the washing solution Q of the developing tank 42 are the same region. Although the same region means that carrying-in and carrying-out of the flexographic printing plate precursor 32 with respect to the washing solution Q are performed in the same region, regions for carrying-in and carrying-out of the flexographic printing plate precursor 32 may include a transport error and are not limited to a complete match.

Although the first region Di and the second region D₂ are the same region, the washout processor 12b is not limited thereto, and the first region Di and the second region D₂ may be regions different from each other. In this case, for example, by changing a transport path through which the flexographic printing plate precursor 32 is carried into the developing tank 42 and a transport path through which the flexographic printing plate precursor is carried out from the developing tank 42, the first region Di and the second region D₂ can be made regions different from each other. A transport path difference between carrying-in and carrying-out of the flexographic printing plate precursor 32 is a difference exceeding a transport error of carrying-in and carrying-out of the flexographic printing plate precursor 32 described above.

The plurality of brushes 71 are rotated about a rotation axis (not shown) by a driving unit (not shown). In addition, during development, the washing solution Q or a regenerated washing solution is supplied to the brushes 71 via the rotation axis. The washing solution Q or the regenerated washing solution is supplied from the brushes 71 to the plate surface 32a of the flexographic printing plate precursor 32.

The plate surface 32a of the flexographic printing plate precursor 32 is rubbed by the plurality of brushes 71, and development is performed by removing a non-exposed portion (not shown) of the flexographic printing plate precursor 32.

For example, brushes obtained by bundling bristles perpendicular to a substrate are used as the brushes 71. In the configuration, the bristles of the brushes 71 are substantially perpendicular to the plate surface 32a of the flexographic printing plate precursor 32. The bristles of the brushes 71 are not particularly limited. The bristles are made of the same material as that of the brush 44 (see Fig. 6) described above.

The brushes 71 may be stationary, that is, fixed to the plate surface 32a of the flexographic printing plate precursor 32 or may be configured to move with respect to the plate surface 32a of the flexographic printing plate precursor 32. In this case, the movement of the brushes 71 is not particularly limited and may be any one of rotation, reciprocation, a combination of rotation and reciprocation, or eccentric movement.

In a case where the brushes 71 move, the brushes 71 may move at all times during development or may move only when the flexographic printing plate precursor 32 is transported to the developing tank 42. In this case, for example, a sensor (not shown) that detects the flexographic printing plate precursor 32 is provided at the transport roller 72 through which the flexographic printing plate precursor 32 first passes, a time when the brushes 71 are reached is identified using a transport timing and the transportation speed of the flexographic printing plate precursor 32, and development can be performed by moving the brushes 71.

The washout processor 12b has a replenishment pump 74 and a replenishment tank 75. The replenishment tank 75 stores the washing solution Q. The washing solution Q stored in the replenishment tank 75 is supplied into the developing tank 42 by the replenishment pump 74.

In addition, the washout processor 12b has a rinsing unit 77. The rinsing unit 77 supplies a rinsing liquid to the plate surface 32a of the flexographic printing plate precursor 32 and removes residues remaining on the plate surface 32a of the developed flexographic printing plate precursor 32 such as latex components and rubber components using the rinsing liquid.

The rinsing liquid is, for example, a liquid of which water is substantially the only component. For example, fresh water, tap water, industrial water, ground water, and the like can be used as the rinsing liquid. The substantially only water means that water is 99.50% by mass or more as a component of the rinsing liquid, and water preferably exceeds 99.99% by mass and is most preferably only water.

The rinsing unit 77 has a rinsing liquid supply unit 77a and a liquid drain nozzle 77b.

The liquid drain nozzle 77b is provided on a downstream side of the rinsing liquid supply unit 77a in the traveling direction D_{L} of the flexographic printing plate precursor 32, that is, a downstream side in the carry-in direction Di.

The rinsing liquid supply unit 77a supplies, for example, a rinsing liquid from a nozzle to the plate surface 32a of the flexographic printing plate precursor 32.

For example, the sensor (not shown) that detects the flexographic printing plate precursor 32 is provided, a timing when the flexographic printing plate precursor 32 passes through the brushes 71 on a base side is detected, and the rinsing liquid is supplied from the rinsing liquid supply unit 77a of the rinsing unit 77 to at least the plate surface 32a of the developed flexographic printing plate precursor 32 from which a non-exposed portion is removed via the nozzle.

The liquid drain nozzle 77b removes the rinsing liquid supplied to the flexographic printing plate precursor 32 by the rinsing liquid supply unit 77a by jetting a gas or removes the rinsing liquid by sucking a gas. Insofar as the jetting of the gas or the sucking of the gas can be performed, the configuration of the liquid drain nozzle 77b is not particularly limited, and various types of pumps can be used.

As the rinsing unit 77 is provided with the rinsing liquid supply unit 77a and the liquid drain nozzle 77b, the liquid drain nozzle 77b entrains the rinsing liquid from the rinsing liquid supply unit 77a, the rinsing liquid spreads on the plate surface 32a of the flexographic printing plate precursor 32 even in a case where a supply amount of the rinsing liquid from the rinsing liquid supply unit 77a is small, and thereby the non-exposed portion described above can be removed. Accordingly, the amount of the rinsing liquid necessary for removing residues such as latex components and rubber components remaining on the plate surface 32a of the developed flexographic printing plate precursor 32 can be decreased.

It is preferable to drive the rinsing liquid supply unit 77a and the liquid drain nozzle 77b simultaneously. By driving the rinsing liquid supply unit 77a and the liquid drain nozzle 77b simultaneously, the effect of entrainment of the rinsing liquid described above is further obtained.

In the washout processor 12b, a portion in contact with the resin aggregate is, for example, the gas-liquid interface of the washing solution Q at the inner wall surface 42g of the developing tank 42. That is, the liquid level Qs of the washing solution Q is the portion 42h that is in contact with the developing tank 20. In addition, the inner wall 25a of the tank 25 (see Fig. 1) is also the portion in contact with the resin aggregate, as in the washout processor 12 described above.

As described above, the portion in contact with the resin aggregate is composed of polyethylene having a critical surface tension of 31 mN/m or less and a dynamic friction coefficient of 0.2 or less or an average molecular weight of 750,000 to 6,000,000. The portion in contact with the resin aggregate can be configured to have the same composition as that of the washout processor 12 described above.

The portion in contact with the resin aggregate may have a configuration integrated with the developing tank 42 or may have a separate configuration.

### <Washing Method>

A washing method of the washout processor 12b will be described. Through washing as described above, the flexographic printing plate precursor 32 is developed, obtaining a flexographic printing plate.

In the washout processor 12b, development is performed in a state where the brushes 71 are in the washing solution Q. Accordingly, an aggregate is prevented from being deposited on the brushes 71, and solid contents accumulated in the brushes 71 are prevented from being peeled off and attached to the flexographic printing plate precursor 32.

The washing solution Q of the developing tank 42 is circulated via the filter 27 and the heater 49 by the pump 26 with the first valve 50 and the third valve 54 opened and is heated to a set temperature. In a case where the set temperature is a temperature of 50°C and the temperature is in a constant state of 50°C, the first valve 50 is closed, the fifth valve 50b is opened, and the washing solution Q is supplied to a brush 71 side, circulating the washing solution Q.

For example, in a case where the brushes 71 have a plurality of bristles implanted in a substrate, the washing solution Q supplied to each brush 71 is jetted from between the implanted bristles through holes in the substrate. In this state, the flexographic printing plate precursor 32 is slid on the transport rollers 72 and is moved in the carry-in direction Di. Then, for example, the brushes 71 are moved eccentrically, performing development.

After the development, the flexographic printing plate precursor 32 is moved in the traveling direction D_{L}. In this case, the flexographic printing plate precursor 32 is carried out from the washing solution Q.

After development, the rinsing unit 77 raises the flexographic printing plate precursor 32 from the washing solution Q while jetting a rinsing liquid to the plate surface 32a of the flexographic printing plate precursor 32. In this case, in a state where the first valve 50, the fifth valve 50b, and the third valve 54 are closed and the second valve 52 and the fourth valve 56 are opened, the washing solution Q is flowed by the pump 26. In this case, in the second region D₂ (see Fig. 9) including the interface between the flexographic printing plate precursor 32 and the washing solution Q described above, a flow of the washing solution Q is formed in the direction Fi (see Fig. 9) as described above. Accordingly, solid contents are prevented from being attached to the flexographic printing plate precursor 32 as the solid contents floating in the second region D₂ are swept away by the flow of the washing solution Q, thereby obtaining a good development finish.

In a case where the flexographic printing plate precursor 32 is moved in a transport direction and is raised from the washing solution Q of the developing tank 42 in a state where the second valve 52 is closed and a state where the first valve 50 and the fifth valve 50b are opened, a flow of the washing solution Q is not formed in the direction Fi, and the solid contents cannot be prevented from being attached to the flexographic printing plate precursor 32 in the second region D₂ described above.

As shown in Fig. 8, the second region D₂ is also the first region Di where the flexographic printing plate precursor 32 is carried in. That is, as described above, the first region Di and the second region D₂ are the same region.

In the washing method, a used washing solution from which the resin aggregate is removed using the regeneration treatment apparatus 14 is also used.

In the washing method, a timing when the resin aggregate is removed by the regeneration treatment apparatus 14 is, for example, a case where the concentration of solid contents of the washing solution Q in the tank 25 exceeds a set concentration or a case where a treatment area of the flexographic printing plate precursor 32 exceeds a set treatment area. The used washing solution in the tank 25 is supplied to the rotating body 36 of the regeneration treatment apparatus 14 by the pump 16, as in the first example of the regeneration treatment method described above, the resin aggregate is removed from the used washing solution, and the used washing solution from which the resin aggregate is removed is transferred to the tank 25 through the pipe 15b.

### (Fourth Example of Washout Processor)

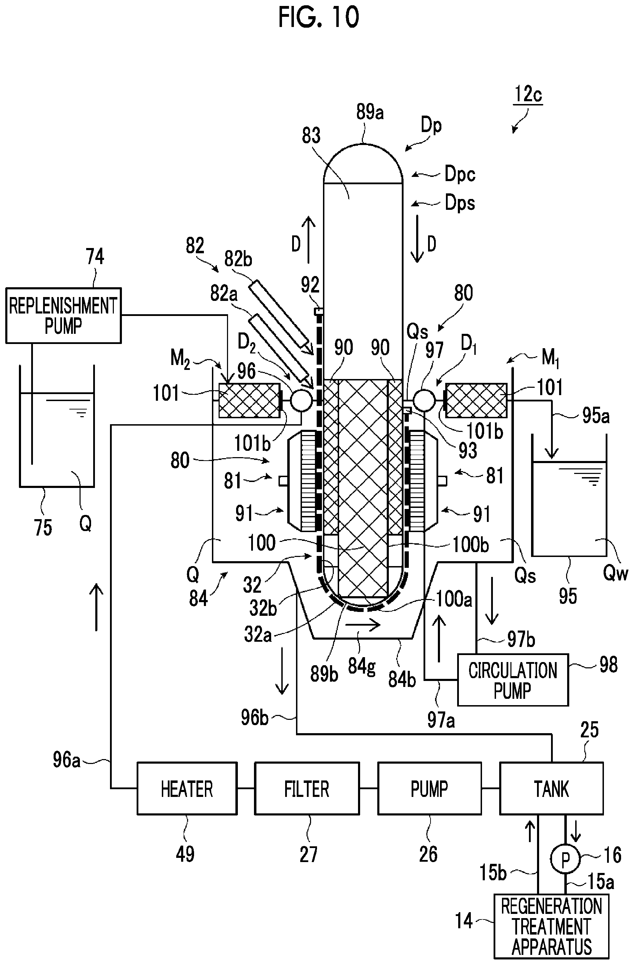

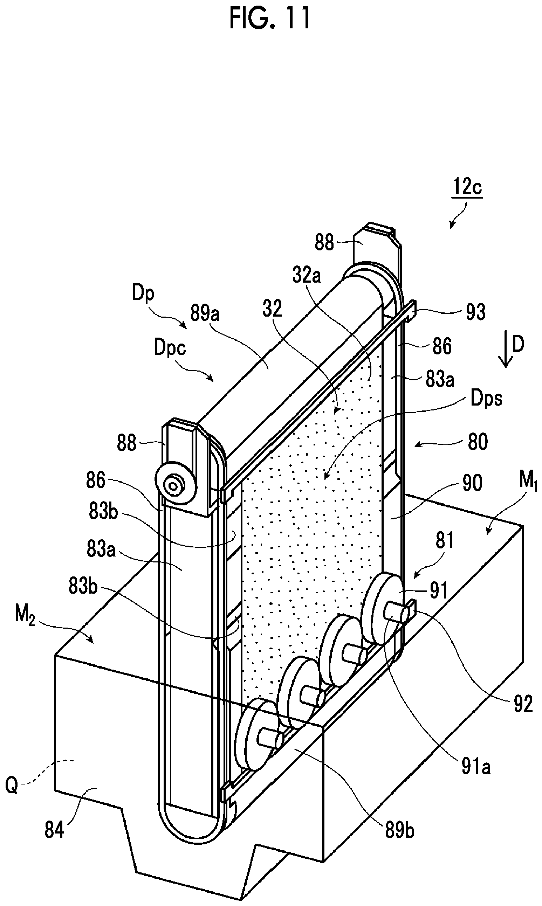

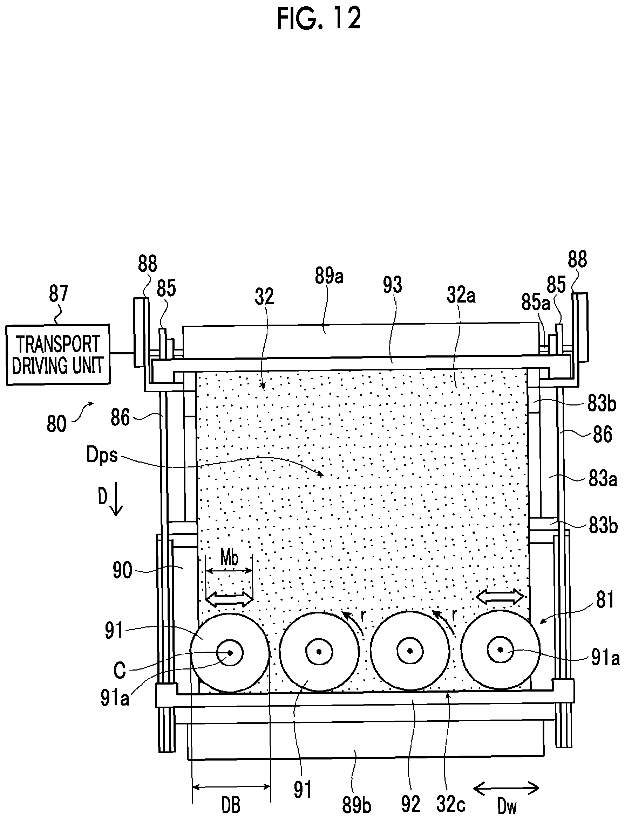

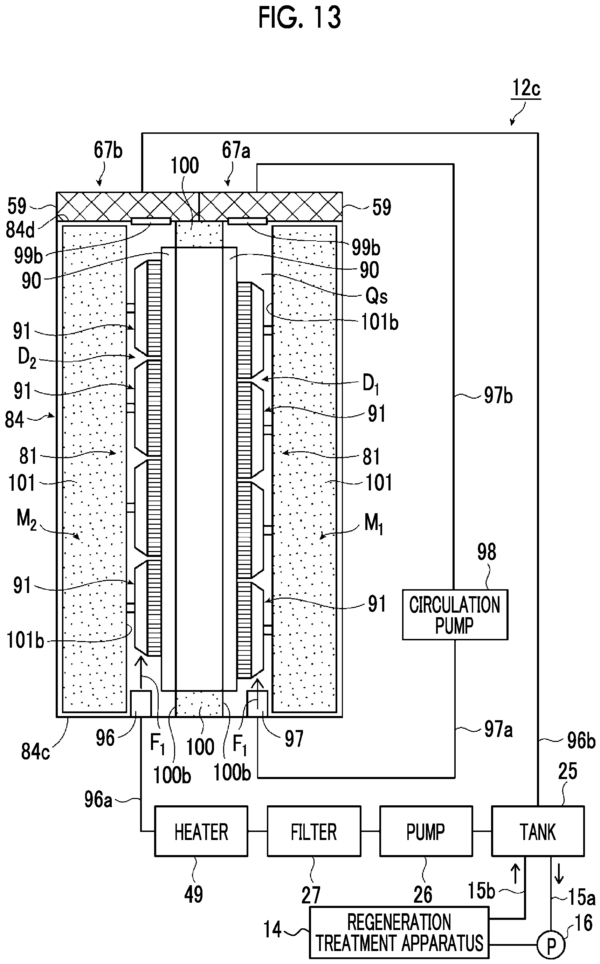

Fig. 10 is a schematic side view showing a fourth example of the washout processor according to the embodiment of the present invention, Fig. 11 is a schematic perspective view showing main portions of the fourth example of the washout processor according to the embodiment of the present invention, Fig. 12 is a schematic plan view showing the main portions of the fourth example of the washout processor according to the embodiment of the present invention, and Fig. 13 is a schematic plan view showing the fourth example of the washout processor according to the embodiment of the present invention.

In Figs. 10 to 13, the same components as those of the washout processor 12a shown in Figs. 6 and 7 will be assigned with the same reference numerals, and detailed description thereof will be omitted. In addition, in Fig. 11, a partition member 100 and a restricting member 101 are not shown.

A washout processor 12c shown in Fig. 10 is a vertical transport type washout processor. The washout processor 12c is an apparatus that develops the imagewise exposed flexographic printing plate precursor 32, of which the plate surface 32a is imagewise exposed, using the washing solution Q, while transporting the flexographic printing plate precursor and is a washout processor that develops the flexographic printing plate precursor 32 in a state of being transported along a determined transport path Dp. Performing development using the washing solution Q described above is referred to as the developing step. As shown in Fig. 10, the transport path Dp for the flexographic printing plate precursor 32 has a curved transport passage Dpc and linear transport passages Dps. The transport path Dp shown in Fig. 10 is a go-around transport path having the curved transport passage Dpc, the linear transport passage Dps, and the curved transport passage Dpc. For this reason, as will be described later, the flexographic printing plate precursor 32 can be developed by making the flexographic printing plate precursor go around a plurality of times.

The flexographic printing plate precursor 32 has a small thickness of approximately several millimeters and is flexible enough to be curved and transported in a developing tank 84.

In the washout processor 12c, the imagewise exposed flexographic printing plate precursor 32, which is in a state of being immersed in the washing solution Q and being transported, is developed with a non-exposed portion (not shown) of the flexographic printing plate precursor 32 removed. The washout processor 12c is an apparatus that performs development while transporting the flexographic printing plate precursor 32 along the determined transport path. In a washing method using the washout processor 12c, the flexographic printing plate precursor 32 is developed while being transported along the determined transport path Dp.

The expression that while transporting the flexographic printing plate precursor 32 described above and a state where the flexographic printing plate precursor 32 is transported mean moving the flexographic printing plate precursor 32 along the transport path Dp.

The washout processor 12c has a transporting unit 80, a development unit 81, and a rinsing unit 82.

Although the transporting unit 80 and the development unit 81 are provided at a frame 83 in the washout processor 12c, the invention is not limited to the configuration.

In the washout processor 12c, for example, the flexographic printing plate precursor 32 that has gone through the rinsing unit 82 is taken out. A position where the flexographic printing plate precursor 32 in the washout processor 12c is taken out is not particularly limited.

The outer shape of the frame 83 is, for example, a rectangular shape. Two members 83a of the frame 83 extending in one direction as shown in Fig. 11 are disposed in parallel. In a direction orthogonal to a longitudinal direction of the members 83a, beam members 83b are disposed at both ends and the center of the members 83a in the longitudinal direction. Between the beam members 83b provided at both ends of the member 83a of the frame 83 in the longitudinal direction is the linear transport passage Dps. For example, up to the center of the members 83a of the frame 83, that is, up to the beam member 83b at the center, the linear transport passage is disposed in the developing tank 84. The developing tank 84 is a container in which the washing solution Q is stored. The development unit 81 is disposed in the linear transport passage Dps in the developing tank 84.

The developing tank 84 has a first tank portion Mi and a second tank portion M₂ with which the washing solution Q communicates. The flexographic printing plate precursor 32 is carried into the first tank portion Mi, and the developed flexographic printing plate precursor 32 is carried out from the second tank portion M₂. The first region Di is in the first tank portion Mi, and the second region D₂ is in the second tank portion M₂. The first region Di includes the interface between the flexographic printing plate precursor 32 and the washing solution Q.

As shown in Fig. 12, for example, gears 85 are rotatably provided at both ends of each member 83a in the longitudinal direction. The gears 85 facing each other in the longitudinal direction of the beam members 83b are connected by a shaft 85a. In each member 83a, a transport chain 86 is hung on a pair of gears 85 facing each other in the longitudinal direction. The pair of transport chains 86 are disposed to face each other in the longitudinal direction of the beam members 83b of the frame 83.

For example, a transport driving unit 87 is connected to one of the plurality of gears 85. The gears 85 are rotated by the transport driving unit 87, and the transport chains 86 move in a specific direction. A method of connecting between the gears 85 and the transport driving unit 87 is not particularly limited. The gears and the transport driving unit may be connected to each other by a shaft or the like or may be connected to each other using a chain or a belt.

The transporting unit 80 is composed of the gears 85, the transport chains 86, and the transport driving unit 87. The flexographic printing plate precursor 32 is transported by the transporting unit 80 in a state of being immersed in the washing solution Q in the developing tank 84.

The transporting unit 80 preferably has a tension adjusting unit 88 (see Fig. 11) that adjusts the tension of the flexographic printing plate precursor 32 during transporting. In a case where the tension of the transport chain 86 is low, the tension of the flexographic printing plate precursor 32 during transporting is low, the flexographic printing plate precursor 32 is loosened during transporting, and the flexographic printing plate precursor 32 is not stably transported. In addition, in a case where the tension of the transport chain 86 is low, the transport chain 86 is disengaged from the gear 85 in some cases. For this reason, the tension adjusting unit 88 that adjusts the tension of the transport chain 86 is provided at an end part of the member 83a in order to adjust the tension of the flexographic printing plate precursor 32 during transporting. The tension of the flexographic printing plate precursor 32 during transporting can be adjusted by the tension adjusting unit 88, and the flexographic printing plate precursor 32 is prevented from being loosened during transporting.

Insofar as the tension of the flexographic printing plate precursor 32 during transporting can be adjusted, a position where the tension adjusting unit 88 is disposed and a configuration thereof are not particularly limited, and a known unit can be used as appropriate. For example, it is possible to use a unit that changes a distance between the gears 85 on which the transport chains 86 are hung, a unit that applies a tension by pressing the gears against the transport chain 86, or the like as appropriate.

The transporting unit 80 may have a guide mechanism that guides the transport chain 86. The guide mechanism can suppress meandering of the transport chain 86 or the like. The guide mechanism is composed of, for example, a member that is provided on an opposite side of the transport chain 86 where the flexographic printing plate precursor 32 is disposed and is inserted between rollers (not shown) of the transport chains 86. This member is composed of, for example, high molecular weight polyethylene or a fluororesin such as polytetrafluoroethylene (PTFE).

A turn bar 89a and a turn bar 89b (see Fig. 11) are provided at the beam members 83b at ends of the members 83a respectively in the longitudinal direction. The turn bars 89a and 89b are composed of a semi-cylindrical member, and the semi-cylindrical member is provided with a plane portion facing a beam member 83b side.

The semi-cylindrical turn bars 89a and 89b are provided at bending parts composed of the curved transport passages. That is, the curved transport passages Dpc are composed of the semi-cylindrical turn bars 89a and 89b, and the flexographic printing plate precursor 32 is transported along the surfaces of the turn bars 89a and 89b. In this case, a back surface 32b of the flexographic printing plate precursor 32 comes into contact with the turn bars 89a and 89b. The turn bars 89a and 89b each are composed of a semi-cylindrical member having a size corresponding to the curvature of the curved transport passage Dpc or the like.

Since the turn bars 89a and 89b are brought into contact with the flexographic printing plate precursor 32, at least, surfaces brought into contact with the flexographic printing plate precursor 32 preferably have a low frictional resistance. As the frictional resistance is low, the flexographic printing plate precursor 32 can be smoothly transported without damaging the back surface 32b. The turn bars 89a and 89b suppress tension fluctuations in the curved transport passages Dpc during transporting of the flexographic printing plate precursor 32.

The turn bar 89a and the turn bar 89b are provided at the ends of the members 83a in the longitudinal direction, and the turn bar 89b is immersed in the developing tank 84 storing the washing solution Q.

In addition, the flexographic printing plate precursor 32 is attached to a trailing end leader 93 in a state where the flexographic printing plate precursor 32 is hung on the turn bar 89a among the turn bar 89a and the turn bar 89b. The turn bar 89a moves forward and backward with respect to the curved transport passage Dpc. In a case where the turn bar 89a has entered the curved transport passage Dpc, the turn bar is brought into contact with the flexographic printing plate precursor 32. On the other hand, in a case where the turn bar 89a has moved backward with respect to the curved transport passage Dpc, a transport length of the flexographic printing plate precursor 32 is shortened, and a short pass state is caused. Specifically, as the turn bar 89a moves up and down with respect to the beam members 83b, the turn bar moves forward and backward with respect to the curved transport passage Dpc. For example, a linear motion mechanism using a solenoid is provided, for example, between the turn bar 89a and the beam member 83b. For example, a configuration where the turn bar 89a is lowered in a state where the solenoid is turned off and the turn bar 89a is raised in a state where the solenoid is turned on is adopted. Accordingly, in a case of fixing the flexographic printing plate precursor 32, the turn bar 89a can be lowered.

By raising and lowering the turn bar 89a, a tension applied to the flexographic printing plate precursor 32 can be changed. The turn bar 89a functions as a tension applying unit. After fixing both a leading end and a trailing end of the flexographic printing plate precursor 32 by a leading end leader 92 and the trailing end leader 93 shown in Fig. 12 with the tension applying unit, by raising the turn bar 89a after fixing the flexographic printing plate precursor 32 to the leader, a force is applied in a direction in which the length of the flexographic printing plate precursor 32 extends in a state where the flexographic printing plate precursor 32 is fixed to the leader, and the tension of the flexographic printing plate precursor 32, that is, a tension after fixing the flexographic printing plate precursor 32 to the leader can be made higher than a tension in a case of fixing the flexographic printing plate precursor 32. The leading end leader 92 and the trailing end leader 93 shown in Fig. 12 are collectively referred to as a leader.

The tension in a case of fixing the flexographic printing plate precursor 32 is the tension of the flexographic printing plate precursor 32 in a state where the turn bar 89a is lowered. The tension after fixing the flexographic printing plate precursor is the tension of the flexographic printing plate precursor 32 in a state where the turn bar 89a is raised.

The magnitude of the tension of the flexographic printing plate precursor 32 can be identified by the tension of the flexographic printing plate precursor 32.

In a case where the tension of the flexographic printing plate precursor 32 is high, that is, the flexographic printing plate precursor 32 extends, vertical creases are generated in the flexographic printing plate precursor 32. On the other hand, in a case where the tension of the flexographic printing plate precursor 32 is low, that is, the flexographic printing plate precursor 32 loosens, horizontal creases are generated. Both the vertical creases and the horizontal creases cause development defects. An operator visually checks the vertical creases and the horizontal creases and can start transporting with a state where none of the creases are generated as an appropriate tension. It is preferable to provide a device that measures the tension of the flexographic printing plate precursor 32 in the tension applying unit or the transport path and to adjust the tension of the flexographic printing plate precursor 32 such that the tension is within a certain range.

Next, the device that measures the tension of the flexographic printing plate precursor 32 or the like will be described.

In a state where the flexographic printing plate precursor 32 is fixed to the leader, a state where the turn bar 89a is raised is visually checked with the solenoid turned on, and a position where the solenoid is attached or a stopper is adjusted to cause a state where vertical creases and horizontal creases are not generated. In addition to the solenoid, an air cylinder or a hydraulic actuator may be used as the linear motion mechanism, and the attachment position or the stopper is adjusted and fixed such that any linear motion mechanism is in an appropriate tension state in a case of being turned on.

In addition, in a case where a drive unit or an electric actuator composed of a ball screw, a linear guide, a servo motor, or the like is used, linear motion can be randomly made not only in an on and off states but also in a certain range, and the tension can be finely adjusted. In a case where the linear motion mechanisms are configured to operate the tension applying unit via a load cell or a strain gauge, a tension applied to the flexographic printing plate precursor 32 can be measured. By quantifying a tension range in a state where vertical creases and horizontal creases are not visually generated in the flexographic printing plate precursor 32, in a state where the flexographic printing plate precursor 32 is fixed to the leader according to various types such as a width, a length, and a thickness of the flexographic printing plate precursor 32, a state where the turn bar 89a is raised with the solenoid turned on is visually checked, and a position where the solenoid is attached or the stopper is adjusted to cause a state where vertical creases and horizontal creases are not generated. In addition to the solenoid, an air cylinder or a hydraulic actuator may be used as the linear motion mechanism, and the attachment position or the stopper is adjusted and fixed such that any linear motion mechanism is in an appropriate tension state in a case of being turned on.

In addition, in a case where the drive unit or the electric actuator composed of the ball screw, the linear guide, the servo motor, or the like is used, linear motion can be randomly made not only in on and off states but also a certain range, and a tension applied to the flexographic printing plate precursor 32 can be finely adjusted. In a case where the linear motion mechanisms are configured to operate the tension applying unit via a load cell or a strain gauge, a tension applied to the flexographic printing plate precursor 32 can be measured. By quantifying a tension range in a state where vertical creases and horizontal creases are not visually generated in the flexographic printing plate precursor 32, an appropriate tension state according to various types such as the width, the length, and the thickness of the flexographic printing plate precursor 32 is easily set.

As a tension measurer, a tension controller is preferable.

The tension applying unit is not limited to the turn bar 89a described above, and a roller (not shown) can also be used instead of the turn bar 89a. In a case where the roller is provided, as in the turn bar 89a described above, the roller is configured to move forward and backward with respect to the curved transport passage Dpc, and a tension can be applied to the flexographic printing plate precursor 32 in a case where the roller has entered the curved transport passage Dpc.

The surfaces of the turn bars 89a and 89b, which are brought into contact with the flexographic printing plate precursor 32, are composed of, for example, resin layers, plating layers, or diamond-like carbon layers (DLC layers). The resin layer can be formed of a fluororesin, such as polytetrafluoroethylene (PTFE) and high-density polyethylene. The plating layer is, for example, hard chrome plating. In addition thereto, a titanium nitride (TiN) layer or the like can be used. Further, a nonwoven fabric can also be used as the turn bars 89a and 89b. In a case of using the nonwoven fabric, an attachment on the back surface 32b of the flexographic printing plate precursor 32 can be removed.

In addition, a plurality of uneven portions may be formed in the surfaces of the turn bars 89a and 89b, which are brought into contact with the flexographic printing plate precursor 32. As the plurality of uneven portions are formed, a contact area reduces, and a frictional resistance decreases. An example in which the plurality of uneven portions are formed includes a metal plate such as an embossed stainless steel plate.

The turn bars 89a and 89b may be entirely formed of a material forming the surfaces brought into contact with the flexographic printing plate precursor 32.

Since the turn bar 89b is used in a state of being immersed in the washing solution Q in some cases, it is preferable that the turn bar 89b does not dissolve in the washing solution Q, does not deteriorate due to the washing solution Q, or does not deform, such as swelling, due to the washing solution Q.

In addition, a back plate portion 90 with which the flexographic printing plate precursor 32 is brought into contact is provided between the beam member 83b at the center of the member 83a of the frame 83 and the beam member 83b at the end. For example, the back plate portion 90 is provided on a back surface 32b side of the flexographic printing plate precursor 32.

Since the back plate portion 90 is brought into contact with the flexographic printing plate precursor 32, a surface brought into contact with the flexographic printing plate precursor 32 is preferably a plane. As the surface brought into contact with the flexographic printing plate precursor 32 is a plane, the flexographic printing plate precursor 32 can be efficiently washed.

The back plate portion 90 is composed of, for example, a metal. The metal is preferably stainless steel, titanium, or the like, the surface of the back plate portion 90 brought into contact with the flexographic printing plate precursor 32 may be plated, and the plating is preferably hard chrome plating and is more preferably diamond-like carbon (DLC) processing. In addition thereto, surface treatment with titanium nitride (TiN) or the like may be performed on the surface brought into contact with the flexographic printing plate precursor 32.

In addition, for example, nip rolls (not shown) may be provided to face the back plate portion 90 at intervals in the longitudinal direction of the members 83a. Although the flexographic printing plate precursor 32 has flexibility, the nip rolls suppress deflection or the like during transporting so that the flexographic printing plate precursor 32 can be stably transported, and even in a case where a brush 91 rotates or moves particularly during development, the flexographic printing plate precursor 32 can be stably transported. The nip rolls are not limited to three.

In order not to damage the printing surface, that is, the plate surface 32a of the flexographic printing plate precursor 32, for example, rubber rollers, sponge rollers, rotary brushes, or the like are preferably used as the nip rolls.

Since the flexographic printing plate precursor 32 has flexibility as described above, there is a possibility that a non-exposed portion cannot be efficiently removed by the brush 91 due to deflection or the like in a case of being rubbed against the brush 91. As the back plate portion 90 described above is provided, the back surface 32b of the flexographic printing plate precursor 32 is supported by the back plate portion 90 in a case of removing the non-exposed portion by the brush 91, so that the non-exposed portion can be efficiently removed. In addition, the back plate portion 90 functions as a transport guide, and thus the flexographic printing plate precursor 32 can be more stably transported by the back plate portion 90.

The development unit 81 (see Fig. 12) may be configured such that a plurality of brushes 91, for example, four brushes 91 are arranged in a line in the direction Dw. The brush 91 is disposed such that a rotation axis C is in a direction perpendicular to the plate surface 32a of the flexographic printing plate precursor 32.

The four brushes 91 are connected to a driving unit (not shown), and the driving unit controls the rotation of the brushes 91 about the rotation axes C and the movement of the brushes 91.

Development can be simultaneously performed by the four brushes 91. Accordingly, an area rubbed by the brushes 91 can be increased, and a development speed can be increased in a state where the attachment of development residues is suppressed and development uniformity is maintained. In this case, the rotation speeds of the plurality of brushes 91 may be the same, or the rotation speed may be changed for each of the plurality of brushes 91. In addition, the sizes of the four brushes 91 may be the same or may be different from each other. However, it is preferable for the four brushes 91 to have the same size and rotation speed from a perspective of development uniformity for suppressing the occurrence of development unevenness.

The rotation about the rotation axis C of the brush 91 described above is rotation of the brush 91 with the rotation axis C as a rotation center, and the brush 91 spins. The rotation axis C is a fixed axis passing through one point in the brush 91. A rotation shaft portion 91a is provided at the brush 91, and a central axis of the rotation shaft portion 91a is the rotation axis C. The rotation shaft portion 91a functions as a rotation drive shaft that is rotated as power is transmitted from the driving unit, and the brush 91 spins, for example, in a rotation direction r as the rotation shaft portion 91a is rotated.

In addition, it is preferable to move the four brushes 91 in a width direction of the flexographic printing plate precursor 32, that is, the direction Dw orthogonal to a transport direction D. That is, it is preferable to swing the plurality of brushes 91 in the direction Dw. In this case, it is preferable to move by a distance of one third or more of a diameter DB (see Fig. 12) of the brush 91. The distance by which the brush 91 is moved in the direction Dw is called a swing width Mb.

As described above, by swinging the brush 91 in the direction Dw, generation of development unevenness can be suppressed. Setting the swing width Mb to the distance of one third or more of the diameter DB (see Fig. 12) of the brush 91 is preferable since generation of development unevenness can be suppressed even better.

In a case where a plurality of brushes are provided, for example, at least two brushes may be simultaneously driven by one motor instead of rotating each brush. In a case of the four brushes 91, the four brushes 91 may be simultaneously driven by one motor instead of rotating each brush 91. Accordingly, the number of motors can be reduced, and thus the device can be decreased in size. In addition, in a case where the plurality of brushes are rotated by one motor, the rotation speed can be changed for each brush 91 by providing a transmission. Accordingly, the number of motors can be reduced, and thus the device can be decreased in size. In addition, in a case where the plurality of brushes are rotated by one motor, the rotation speed can be changed for each brush 91 by providing a transmission.

For the brushes 91, a configuration where two brushes 91 are disposed in the transport direction D of the transport path Dp may be adopted.

In addition, it is preferable that the washout processor 12c has at least two types of brushes used in development, and one type of the at least two types of brushes is a brush of which the rotation axis C is disposed in a direction perpendicular to the flexographic printing plate precursor 32. By disposing the rotation axis C parallel to the plate surface 32a of the flexographic printing plate precursor 32, development can be efficiently performed.

For example, in the development unit 81, a roller brush that is used in finishing of development may be disposed on an upstream side (first region Di) of the transport path Dp for the flexographic printing plate precursor 32 in the transport direction D. The roller brush is disposed in a state of being immersed in the liquid level Qs of the washing solution Q. Having the roller brush that is used in finishing of development is preferable since on-plate residues or the like are removed, but it is not always necessary to provide the roller brush.

As shown in Fig. 12, for example, a plurality of fixing units (not shown) are provided on the transport chain 86 at equal intervals along a longitudinal direction of the transport chain 86. The leading end leader 92 and the trailing end leader 93 are fixed to the fixing units. The longitudinal direction of the transport chain 86 is the same direction as the transport direction D.

A method of fixing the leading end leader 92 to the transport chain 86 is not particularly limited, and the leading end leader is fixed to the transport chain through at least one of fixing methods using hooking, screwing, sandwiching, or a magnetic force.

The hooking is, for example, a method of providing a bending portion at the leading end leader 92 and hooking the bending portion to the fixing unit.

The screwing is, for example, a method of fixing the bending portion to the fixing unit using a bolt and a nut. In addition thereto, a method of forming a female thread in the fixing unit and fixing the bending portion to the fixing unit using a screw is also included in screwing.

The sandwiching is, for example, a method of collectively sandwiching and fixing the bending portion and the fixing unit to each other using a member such as a clip.

Fixing by a magnetic force is, for example, a method of forming the bending portion and the fixing unit by magnetic materials and fixing the bending portion and the fixing unit to each other using magnets.

The trailing end leader 93 has basically the same configuration as that of the leading end leader 92 described above.

A bending portion (not shown) is provided at the trailing end leader 93 and is fixed to the fixing unit of the transport chain 86, and the trailing end leader 93 is fixed to the transport chain 86. A method of fixing the trailing end leader 93 to the transport chain 86 is not particularly limited, and the trailing end leader is fixed to the transport chain through at least one method of fixing methods using hooking, screwing, sandwiching, or a magnetic force, like the leading end leader 92.

Since the leading end leader 92 is on a traveling direction side, a force acts in a direction in which the fixing unit presses the bending portion of the leading end leader 92 even in a case of being hooked. In order to make a force act in the direction in which the bending portion is pressed, it is necessary to hook the bending portion of the trailing end leader 93 in an opposite direction to the leading end leader 92. For this reason, fixing methods using screwing, sandwiching, and a magnetic force, which allow fixing in states of Fig. 12, are preferable for the trailing end leader 93.

In addition, a transporting tension fluctuates in some cases due to fluctuations of transporting during transporting. Transporting becomes unstable due to the fluctuations of the transporting tension. In addition, the flexographic printing plate precursor 32 expands and contracts in some cases due to the transporting tension during transporting. For this reason, it is preferable to suppress the fluctuations of the transporting tension and effects of expansion and contraction or the like of the flexographic printing plate precursor 32. Thus, it is preferable for the leader to have a leader mechanism portion (not shown) that expands and contracts with respect to the traveling direction of the flexographic printing plate precursor 32. The leader mechanism portion can reduce the fluctuations of the transporting tension and the effects of expansion and contraction or the like of the flexographic printing plate precursor 32 by expanding and contracting with respect to the traveling direction of the flexographic printing plate precursor 32.

Since the leading end leader 92 is on the traveling direction side, a transporting tension is unlikely to fluctuate, but the transporting tension of the trailing end leader 93 is likely to fluctuate. For this reason, it is preferable for the trailing end leader 93 to have the leader mechanism portion (not shown). The leading end leader 92 may be configured to have the leader mechanism portion.

The washout processor 12c is not limited to a form in which the leading end leader 92 and the trailing end leader 93 are attached to one flexographic printing plate precursor 32 as described above, and a plurality of flexographic printing plate precursors may be attached to the leader.

For example, a pin is used as a method of fixing the flexographic printing plate precursor 32 by the leading end leader 92 and the trailing end leader 93.

In addition, it is preferable that the pin has, for example, a barb. Due to the barb, the flexographic printing plate precursor 32 is unlikely to come off from the pin, and the flexographic printing plate precursor 32 is reliably fixed. The barb is a protruding portion of the pin.

In addition, it is preferable that a surface of the pin brought into contact with at least the flexographic printing plate precursor 32 has a resin layer, a plating layer, or a diamond-like carbon layer (DLC layer) or a plurality of uneven portions are formed on the surface brought into contact with the flexographic printing plate precursor 32.

A hard chrome plating layer is preferable as the plating layer. In addition thereto, surface treatment with titanium nitride (TiN) or the like may be performed on the surface of the pin brought into contact with the flexographic printing plate precursor 32. Accordingly, friction between the pin and the flexographic printing plate precursor 32 is reduced, and the pin is likely to be passed through the flexographic printing plate precursor 32. Further, the durability of the pin improves, the pin can be repeatedly used, and the durability of the leading end leader 92 and the trailing end leader 93 also improves.

The plurality of uneven portions of the surface of the pin brought into contact with the flexographic printing plate precursor 32 are formed through, for example, embossing.

In the washout processor 12c, the development unit 81 and the rinsing unit 82 are provided along the transport path Dp for the flexographic printing plate precursor 32. For example, the development unit 81 is provided in the developing tank 84, and the rinsing unit 82 is provided at an upper portion of the developing tank 84 where the flexographic printing plate precursor 32 that has gone through the development unit 81 first comes out. That is, the rinsing unit 82 is provided at an upper portion of the second tank portion M₂.

The rinsing unit 82 is provided on a downstream side of the development unit 81 in the traveling direction of the flexographic printing plate precursor 32. Herein, the downstream side is a side in a direction in which a leading end 32c (see Fig. 12) of the flexographic printing plate precursor 32 advances in a case of transporting the flexographic printing plate precursor 32. In addition, downstream is a destination where the leading end advances in the transport direction D of the flexographic printing plate precursor 32. An opposite side of the downstream side is an upstream side.

Further, the washout processor 12c has a waste liquid tank 95 provided at the developing tank 84 via a connecting pipe 95a as shown in Fig. 10. The washing solution Q or a fatiqued developer Qw, which is the developed washing solution Q, overflowing from the developing tank 84 is transferred to the waste liquid tank 95 through the connecting pipe 95a.

In addition, a supply port 96 is provided in a side surface 84c of the developing tank 84 on a side where the rinsing unit 82 is provided. The supply port 96 is connected to the heater 49 via a pipe 66a. In addition, as shown in Fig. 13, the filter 59 is provided at a side surface 84d of the developing tank 84 to face the supply port 96. A pipe 96b is provided via the filter 59. The pipe 96b is connected to the pump 26.

A second flow creation unit 67b that flows the washing solution Q in the second tank portion M₂ in the intersecting direction to cross the width Ws of the flexographic printing plate precursor 32 is composed of the pump 26, the filter 27, the heater 49, the filter 59, the supply port 96, and the pipe 96b.

In addition, a supply port 97 is provided in the side surface 84c of the developing tank 84 on a side where the rinsing unit 82 is not provided. The supply port 97 is connected to a circulation pump 98 via a pipe 97a. The filter 59 is provided at the side surface 84d of the developing tank 84 to face the supply port 97. A pipe 97b is provided at the filter 59. The pipe 97b is connected to the circulation pump 98. A first flow creation unit 67a that flows the washing solution Q in the first tank portion Mi in the intersecting direction to cross the width Ws of the flexographic printing plate precursor 32 is composed of the supply port 97, the pipe 97a, and the circulation pump 98.

### (Transporting Unit)

In the transporting unit 80, the gear 85 is rotated by the transport driving unit 87, and the flexographic printing plate precursor 32 fixed to the transport chain 86 using the leading end leader 92 and the trailing end leader 93 moves in the vicinity of the frame 83. The transport path Dp for the flexographic printing plate precursor 32 is a path for going around the vicinity of the frame 83 and has the curved transport passage Dpc and the linear transport passage Dps.

In the washout processor 12c, for example, after one time of development, processing by the rinsing unit 82 is performed and ended. A rinsing step is performed after the developing step of performing development. However, development is not limited to one time, and the flexographic printing plate precursor may go around the vicinity of the frame 83 a plurality of times in order to perform development a plurality of times.

Although there are various transport paths such as a one-direction transport path, a reciprocating transport path, and a go-around transport path as the transport path Dp for the flexographic printing plate precursor 32, it is preferable that the transport path Dp for the flexographic printing plate precursor 32 is the one-direction transport path or the go-around transport path since processing by the rinsing unit 82 is necessary after development.

### (Development Unit)

Insofar as a non-exposed portion (not shown) of the flexographic printing plate precursor 32 can be removed and developed, the configuration of the development unit 81 is not particularly limited and is not limited to development using the brush 91 to be described later. The configuration of the brush is also not particularly limited, and a rotary brush and a brush having a rotation axis parallel to the nip roll can also be used in addition to the configuration of the brush 91 to be described later. In this case, a roller-shaped brush in which bristles are bundled radially with respect to a rotation axis can be used. In the development unit 81, the configuration of the brush, the number of brushes, and the like are not particularly limited.

The development unit 81 develops the flexographic printing plate precursor 32 using the washing solution Q stored in the developing tank 84. Development is performed on the flexographic printing plate precursor 32 in a state of being immersed in the washing solution Q in the developing tank 84 and being transported.

In the development unit 81, the fatiqued developer Qw is generated in the developing tank 84 due to development by the brush 91. The fatiqued developer Qw is the washing solution Q containing solid contents generated by removing the non-exposed portion (not shown) of the flexographic printing plate precursor 32 due to development using the washing solution Q.

The flexographic printing plate precursor in a state where the non-exposed portion is removed due to development is referred to as a developed flexographic printing plate precursor.

### (Driving Unit)

The driving unit rotates the brush 91 in a state where the rotation axis C of the brush 91 passes through the plate surface 32a of the flexographic printing plate precursor 32. The driving unit moves the rotation axis C of the brush 91 in at least one direction intersecting the rotation axis C. The rotation of the brush 91 and the movement of the brush 91 are controlled by the driving unit unless stated otherwise.

As shown in Fig. 13, the brush 91 is disposed on a plate surface 32a side of the flexographic printing plate precursor 32, and for example, the direction Dw orthogonal to the transport direction D is set as a first moving direction of the brush 91, which intersects the rotation axis C. The brush 91 is configured to move in the direction Dw. In addition, the brush 91 may be configured to be moved in two directions with respect to the rotation axis C. In a case of being moved in two directions, the two directions are not particularly limited insofar as the brush is moved in two directions, may be two directions intersecting the rotation axis C, or may be two directions orthogonal to the rotation axis C. Specifically, for example, the first moving direction is the direction Dw, and a second moving direction is the transport direction D. Insofar as the brush 91 can uniformly rub the entire plate surface 32a of the flexographic printing plate precursor 32, the moving directions of the brush 91 are not particularly limited. Insofar as the brush 91 is configured to be moved in two directions orthogonal to each other, the entire plate surface 32a of the flexographic printing plate precursor 32 can be uniformly rubbed by the brush 91, and development uniformity improves. Further, the development speed also improves by moving the brush 91 in the two directions orthogonal to each other.

In a case where the four brushes 91 are arranged along the transport direction D of the flexographic printing plate precursor 32, it is preferable to change at least one of a density at which bristles are planted or the thickness of the bristles in the first brush 91 and the second brush 91. While development proceeds even with the same processing time with a brush having high-density or thick bristles, a finished state related to print quality, such as independent small dots, deteriorates in some cases. Thus, in a case of disposing two or more brushes 91 in the transport direction D, it is preferable to first dispose a type of brush that makes development progress quickly and to dispose a type of brush that is excellent in development treatment quality as a brush in the latter half of the development.

### <Brush>

The brush 91 performs development by removing a non-exposed portion (not shown) of the flexographic printing plate precursor 32. For example, the brush 91 is immersed in the washing solution Q and is disposed on the plate surface 32a side of the flexographic printing plate precursor 32 in the transport direction D in the developing tank 84. In a state where the flexographic printing plate precursor 32 is transported, the plate surface 32a of the flexographic printing plate precursor 32 is rubbed as the brush 91 is rotated in the rotation direction r (see Fig. 13) by the driving unit, and development is performed by removing the non-exposed portion (not shown) of the flexographic printing plate precursor 32. During the development, the fatiqued developer Qw described above is generated.

Since the brush 91 is disposed by being immersed in the washing solution Q, the washing solution Q attached to the brush 91 is not dried, and fixing of the non-exposed portion or the like removed by the brush 91 to the brush 91 as development residues is suppressed.

The area of the brush 91, which is obtained by projecting the brush 91 onto the plate surface 32a of the flexographic printing plate precursor 32, is smaller than the area of the plate surface 32a of the flexographic printing plate precursor 32. For this reason, the brush 91 is partially applied with respect to the entire width of the flexographic printing plate precursor 32 and performs development. During development, since the brush 91 is small, the brush 91 moves, for example, in the transport direction D and the direction Dw as described above in order for the brush 91 to uniformly rub the entire plate surface 32a of the flexographic printing plate precursor 32, but may be configured to move only in the direction Dw.

A moving path of the brush 91 is determined in advance according to the size of the brush 91, the size and the transportation speed of the flexographic printing plate precursor 32, or the like. Accordingly, the moving path of the brush 91 is programmed in the driving unit, and the driving unit can move the brush 91 along the moving path to perform development based on a program.

The brush 91 is obtained, for example, by bundling bristles perpendicular to a substrate and has the same configuration as that of the brush 71 described above. The shape of the substrate is the shape of the brush 91. For example, the substrate is circular, but is not particularly limited thereto.

The rotation shaft portion is provided on the substrate. Accordingly, the rotation axis C is provided in the brush 91. In addition, by adjusting a position where the rotation shaft portion is provided, the position of the rotation axis C can be adjusted in the brush 91. The rotation shaft portion can also be provided at a place other than the center of the substrate, but in this case, the brush 91 moves eccentrically.

Herein, the center of the brush 91 is the center of the substrate of the brush 91, that is, the geometric center of a shape obtained by projecting the substrate onto a plane. In a case where the substrate is circular, the center of the circle is the center of the brush 91. In a case where the substrate is rectangular, a point where diagonals of the rectangle intersect each other is the center of the brush 91.

The expression that the rotation axis C of the brush 91 passes through the center of the brush 91 means that the rotation shaft portion 91a is disposed such that the rotation axis C passes through the center of the substrate in a case where the substrate is circular. As the rotation axis C is disposed to pass through the center of the brush 91, the brush 91 can be uniformly brought into contact with the plate surface 32a of the flexographic printing plate precursor 32. For this reason, development uniformity improves.

In addition, as the rotation axis C is disposed to pass through the center of the brush 91, the brush 91 rotates stably in a case where the brush 91 spins. For this reason, the brush can be stably rotated even in a case where the rotation speed is increased in order to increase the rotation speed of the brush 91. Accordingly, the development speed can be increased.

In addition, in a case where the plurality of brushes 91 are disposed in parallel, contact between the brushes 91 can be suppressed even in a case where an interval between the brushes 91 is decreased. For this reason, the rotation axis C of the brush 91 preferably passes through the center of the brush 91.

For example, a brush called a cup brush is used as the brush 91. It is preferable that the bristles of the brush 91 are used by being applied substantially perpendicular to the plate surface 32a of the flexographic printing plate precursor 32.

The brush 91 is smaller than the flexographic printing plate precursor 32 as described above. As the brush 91 is small, the brush 91 is moved and performs development on the flexographic printing plate precursor 32, the pressure of the brush 91 can be made uniform, and development uniformity can be improved.

Further, since a brush area necessary for development can be reduced as the brush 91 performs development by moving in a plane direction while the flexographic printing plate precursor 32 is transported, the washout processor can be simplified.

The size of the brush 91 is not particularly limited insofar as the brush is smaller than the flexographic printing plate precursor 32. In a case where the outer shape of the substrate of the brush 91 is circular, the diameter DB (see Fig. 12) thereof is preferably 30 mm to 500 mm, the diameter DB is more preferably 100 to 400 mm, and the diameter DB is most preferably 200 to 400 mm.

In a case where the shape of the substrate of the brush 91 is a brush shape other than a circle, an equivalent circle diameter, that is, a diameter corresponding to the brush area is used as the diameter in a case where the outer shape of the substrate described above is circular.

In addition, the brush 91 rotates and performs development, but the rotation speed of the brush 91 is preferably 10 revolutions per minute (rpm) to 2,000 rpm, more preferably 20 to 800 rpm, and even more preferably 30 to 200 rpm.

By increasing the rotation speed of the brush 91 and increasing the rotation speed, the development speed can be increased as described above, and development uniformity also improves.

Herein, as for a mechanism of attachment of development residues, it is estimated that development residues are attached in the brush 91, are transferred and attached to the flexographic printing plate precursor 32 at a certain timing during development. For this reason, it is necessary to efficiently discharge the development residues from the inside of the brush 91 to the outside of the brush 91. Thus, in a case where the rotation speed of the brush 91 is high, the washing solution in the brush 91 is likely to be discharged to the outside of the brush 91 due to rotation, and development residues in the brush 91 can be efficiently discharged to the outside of the brush 91.

In addition, the rotation speed of the brush 91 is not limited to being a fixed value and may be variable. In a case where the rotation speed of the brush 91 is variable, for example, the rotation speed is determined in advance from the initial stage of development to the end of development, and development can be performed at the determined rotation speed.

The substrate of the brush 91 holds the bristles, and for example, the bristles are implanted in a bundle. Insofar as the substrate can hold the bristles and does not become deteriorated due to the washing solution Q, there is no particular limitation.

The material for the bristles of the brush 91 is not particularly limited. For example, natural fibers, such as coir, and any material that can be made into a fibrous form, such as a metal, polyamide, polyester, vinyl chloride, vinylidene chloride, polyimide, and polyacrylonitrile, are suitably used.

The fiber diameter of each bristle of the brush is preferably approximately 10 µ to 1 mm and may be implanted in a bundle or be independently implanted within several bristles. The implanting interval is preferably approximately 1 to 20 mm, and in a case of being implanted in a bundle, the diameter of the bundle is preferably approximately 1 to 10 mm. In addition, the length of each of the bristles of the brush is preferably approximately 2 to 50 mm and more preferably 5 to 25 mm. In a case where the length of each of the bristles of the brush is 5 to 25 mm, the leading end leader 92 and the trailing end leader 93 for transport can be passed through, a brush force becomes strong so that independent small dot performance is obtained, and a development speed thereof also increases.

The length of each of the bristles may vary in one brush 91, and it is preferable that bristles in a central portion are long. In addition, the thickness of each of the bristles in one brush 91 may vary, or the density of the bristles in one brush 91 may vary.

In addition, in a case where bristles obtained by adding a fine abrasive material such as alumina or silicon carbide to a nylon thread are used as a material for the bristles of the brush disposed on a first region Di side, the development speed in the first half of development can be increased, and a development treatment time can be shortened. As the bristles to which the abrasive material is added, wavy bristles, which are not uncurled bristles and which are called curly bristles, can be used rather than straight bristles. Since the abrasive material is contained, abrasion of the brush can be reduced, and the brush life can be extended. Examples of a commercially available bristle material include Sungrid (product name) manufactured by Asahi Kasei Corporation, Tragrid (product name) manufactured by Toray Industries, Inc., and Tynex (product name) manufactured by DuPont. On the other hand, in a case of the brush disposed on a second region D₂ side, there is a possibility that scratches are generated on the flexographic printing plate precursor 32 depending on a type of an abrasive material, and the brush can be used properly according to the region.

The bristles of the brush 91 are bundled on the substrate. The bristles are provided in a region other than a region where a radius with respect to the center of the substrate is within 10 mm. That is, it is preferable that the bristles are not provided in a region where a radius with respect to the rotation axis C is 10 mm, and the bristles are preferably provided in a region other than the region. As described above, it is preferable that in the brush 91, the bristles are not provided in the region where the radius with respect to the rotation axis C is within 10 mm, and the bristles are provided in a region where the radius exceeds 10 mm.

In a case where the bristles are provided in the region of the brush 91 in the region where the radius is within 10 mm, development residues are likely to be discharged, the rotation speed also increases, and independent small dot performance is obtained during development, which is preferable.

In order to maintain the development speed of the brush 91, it is preferable that the bristles are provided in a region of 30% or more of the substrate. The fact that the bristles are provided in an area of 30% or more of the substrate of the brush 91 means that the area of the bristles is 30%.

As described above, the brush 91 is rotated by the driving unit in a state where the rotation axis C of the brush 91 passes through the plate surface 32a of the flexographic printing plate precursor 32. In this case, in a case where an angle formed by the rotation axis C with respect to the plate surface 32a of the flexographic printing plate precursor 32 is set as θ, the angle θ is preferably 30° ≤ θ ≤ 90°, more preferably 45° ≤ θ ≤ 90°, and most preferably 60° ≤ θ ≤ 90°. By setting the angle θ to 60° ≤ θ ≤ 90°, the brush 91 can be uniformly brought into contact with the plate surface 32a of the flexographic printing plate precursor 32, and development can be performed even in a case where the pressure of the brush 91 is increased. For this reason, both the development uniformity and the development speed can be increased. As described above, it is most preferable that the rotation axis C of the brush 91 is perpendicular to the plate surface 32a of the flexographic printing plate precursor 32.

The angle θ can be obtained as follows. First, an image of a state where the brush 91 is disposed on the plate surface 32a of the flexographic printing plate precursor 32 is acquired, and a line corresponding to the rotation axis C of the brush 91 and a line corresponding to the plate surface 32a of the flexographic printing plate precursor 32 are acquired from the image. Next, an angle formed by the two lines is acquired. Accordingly, the angle θ can be obtained.

A state where the rotation axis C of the brush 91 passes through the plate surface 32a of the flexographic printing plate precursor 32 means passing through the plate surface 32a of the flexographic printing plate precursor 32 or a surface obtained by expanding the plate surface 32a of the flexographic printing plate precursor 32 in a case of the rotation axis C or in a case where the rotation axis C is extended, and shows a disposition relationship between the brush 91 and the flexographic printing plate precursor 32.

For this reason, the rotation axis C of the brush 91 does not pass through the actual plate surface 32a of the flexographic printing plate precursor 32 in some cases depending on the inclination of the rotation axis C, but the rotation axis C of the brush 91 is not limited to actually passing through the plate surface 32a of the flexographic printing plate precursor 32 as described above.

The position of the brush 91 with respect to the plate surface 32a of the flexographic printing plate precursor 32 may be fixed. In addition, a configuration where the brush approaches or is spaced apart from the plate surface 32a of the flexographic printing plate precursor 32 may be adopted. As the brush 91 can approach or be spaced apart from the plate surface 32a of the flexographic printing plate precursor 32, the pressure of the brush 91 can be adjusted with respect to the plate surface 32a of the flexographic printing plate precursor 32. Accordingly, the pressure of the brush 91 can be increased, and the development speed can be improved.

In a case where the pressure of the brush 91 is increased, it is preferable that the material for the bristles of the brush 91, the length of each bristle, the thickness of each bristle, or the like corresponds to the pressure. The bristles of the central portion in one brush 91 may be made long, the thickness of each of bristles in one brush 91 may be changed, or the density of the bristles in one brush 91 may be changed.

In addition, as the brush 91 can be spaced apart from the plate surface 32a of the flexographic printing plate precursor 32, the brush 91 can be lifted from the plate surface 32a of the flexographic printing plate precursor 32. Accordingly, in a case where development residues of the brush 91 are attached, the development residues can be removed from the brush 91.

As for the operation of the brush 91, the brush 91 may move at all times during development, or the brush 91 may rotate only in a case where the flexographic printing plate precursor 32 is transported to the developing tank 84. In this case, for example, a sensor (not shown) that detects the flexographic printing plate precursor 32 is provided above the developing tank 84, a time when the brush 91 is reached is identified using a transport timing and the transportation speed of the flexographic printing plate precursor 32, and development can be performed by rotating the brush 91.

In addition, for example, the outside of the flexographic printing plate precursor 32 and the upper side of the plate surface 32a of the flexographic printing plate precursor 32 can be used as a retracting place for the brush 91. The driving unit moves the brush 91 to the retracting place, and the driving unit causes the brush 91 to retract from the flexographic printing plate precursor 32. By retracting the brush 91 from the flexographic printing plate precursor 32, attachment of development residues is suppressed, which is preferable.

In a case where the retracting place is outside the flexographic printing plate precursor 32, the development residues are unlikely to be attached to the plate surface 32a of the flexographic printing plate precursor 32 again, and attachment of the development residues can be further suppressed from attaching compared to a case where the brush 91 is retracted by being simply lifted from the plate surface 32a of the flexographic printing plate precursor 32.

In a case of removing the development residues, in addition to moving the brush 91 to the retracting place, retracting conditions such as a development time and a development treatment area are set, and in a case where the retracting conditions are satisfied, the brush 91 may be configured to be moved to the retracting place. In this case, for example, the sensor (not shown) that detects the flexographic printing plate precursor 32 is provided above the developing tank 84, the retracting conditions are set in the driving unit, the input amount of the flexographic printing plate precursor 32 is identified using the transport timing and the transportation speed of the flexographic printing plate precursor 32, and the retraction of the brush 91 can be controlled.

In addition, in order to efficiently discharge the development residues in the brush 91 to the outside of the brush 91, the washing solution may be supplied to the brush 91 at the retracting place for the brush 91, and the development residues may be discharged to the outside of the brush 91.

### (Rinsing Unit)

The rinsing unit 82 removes residues, such as latex components and rubber components remaining on the plate surface 32a of the developed flexographic printing plate precursor 32 carried out from the development unit 81, using a rinsing liquid such as the washing solution. Removing residues, such as latex components and rubber components remaining on the plate surface 32a of the flexographic printing plate precursor 32, using the rinsing liquid such as the washing solution, by the rinsing unit 82 is called the rinsing step.

The developed flexographic printing plate precursor 32 is transported from the development unit 81, is transported to the outside of the developing tank 84, and is processed by the rinsing unit 82.

The rinsing unit 82 has a rinsing liquid supply unit 82a and a liquid drain nozzle 82b. Since the rinsing liquid supply unit 82a and the liquid drain nozzle 82b have the same configurations of the rinsing liquid supply unit 77a and the liquid drain nozzle 77b shown in Fig. 8, respectively, detailed description thereof will be omitted.

The rinsing unit 82 applies a rinsing liquid, for example, from the rinsing liquid supply unit 82a to the plate surface 32a of the developed flexographic printing plate precursor 32, for example, in a spray-like manner, washing away the residues described above. The fatiqued developer Qw supplied from the rinsing liquid supply unit 82a and the residues, which are washed away and are described above, accumulate in the developing tank 84.

It is preferable that the rinsing unit 82 is provided such that the rinsing liquid is supplied to a liquid film generated by the washing solution remaining on the developed flexographic printing plate precursor 32 carried out from the development unit.

For a reason that the liquid film generated by the washing solution is likely to flow into the developing tank 84 together with the rinsing liquid, a position to which the rinsing liquid is supplied is preferably 50 cm or lower, is more preferably 30 cm or lower, and is even more preferably 15 cm or lower from the liquid level Qs of the washing solution Q.

For example, in Fig. 10, the position where the rinsing liquid is supplied is a position 10 cm from the liquid level.

As the used rinsing liquid supplied from the rinsing unit 82 flows into the developing tank 84, a total waste liquid amount can be reduced. In particular, in a case where the transport path is in an up-down direction, an effect of reducing the waste liquid amount is great. For this reason, it is preferable that the used rinsing liquid flows into the developing tank 84 also in the rinsing step.

The rinsing liquid supply amount of the rinsing liquid supplied for each unit area of the flexographic printing plate precursor to which the rinsing liquid is supplied is preferably sprayed at 0.3 to 7 kg/m² and more preferably at 0.5 to 4 kg/m². As the rinsing liquid supply amount described above is set to 0.3 kg/m² or more, the residues described above, which remain on the plate surface 32a of the developed flexographic printing plate precursor 32, can be stably washed away. On the other hand, as the rinsing liquid supply amount described above is set to 7 kg/m² or less, the inflow amount of rinsing liquid into the developing tank 84 is reduced, and the waste liquid amount can be reduced.

As the rinsing liquid, the washing solution Q to be supplied may be the washing solution Q newly prepared in another tank (not shown).

The washout processor 12c is provided with a partition member 100 along the frame 83, in the developing tank 84. With the partition member 100, a space 84g between a bottom surface 84b of the developing tank 84 and an end part 100a of the partition member 100 is divided into a side where the flexographic printing plate precursor 32 enters the washing solution Q and a side where the flexographic printing plate precursor 32 is discharged from the washing solution Q. That is, the developing tank 84 is configured such that the first tank portion Mi and the second tank portion M₂ communicate with each other in the space 84g due to the partition member 100. For this reason, in the developing tank 84, solid contents floating on the liquid level of the first tank portion M₁, which is the side where the flexographic printing plate precursor 32 enters the washing solution Q, are prevented from moving to the liquid level of the second tank portion M₂, which is the side where the flexographic printing plate precursor 32 is discharged from the washing solution Q. Accordingly, the second tank portion M₂ can maintain a state where the amount of the solid contents is relatively small compared to the first tank portion Mi. The washing solution Q can pass through the space 84g of the developing tank 84 as described above.

In addition, the second tank portion M₂ is replenished with the washing solution Q by the replenishment pump 74. Accordingly, the washing solution Q stored in the developing tank 84 passes through the space 84g of the developing tank 84, and the washing solution Q is pressed out to a first tank portion Mi side where the flexographic printing plate precursor 32 enters. Consequently, for example, the washing solution Q overflows and moves from the developing tank 84 to a tank (not shown). In this case, in a case where the washing solution Q contains solid contents, the solid contents are captured by the filter 59, and the washing solution Q from which the solid contents are removed is transferred to the circulation pump 98 as a regenerated washing solution.

In addition, the washing solution Q or the fatiqued developer Qw, which is the developed washing solution Q, overflowing from the developing tank 84 is transferred to the waste liquid tank 95 through the connecting pipe 95a.

A restricting member 101 is a member that restricts a flow passage for the washing solution Q flowing in the intersecting direction to cross the width of the flexographic printing plate precursor 32 in at least one of the first region D₁ or the second region D₂. The restricting member 101 forms an elongated flow passage through which the washing solution Q flows in the first region D₁ and the second region D₂. In the flow passage, a range where the washing solution Q flows is made narrower than in a case where the restricting member 101 is not provided. Accordingly, in a case of flowing the washing solution Q, diffusion of the washing solution Q is suppressed, and a decrease in the flow rate of the washing solution Q is suppressed.

In addition, by providing the restricting member 101, a decrease in the flow rate of the washing solution Q can be suppressed without making the volume of the developing tank 84 small.

In a case where the developing tank 84 is viewed from the liquid level Qs, the restricting member 101 is a quadrangular member and is disposed with a gap with respect to the brush 91. The gap is a flow passage for the washing solution Q.

The restricting member 101 may be provided in at least one of the first region D₁ or the second region D₂. However, it is preferable that the restricting member 101 is provided in the second region D₂ where the flexographic printing plate precursor 32 is discharged, among the first region D₁ and the second region D₂.

In addition, as a range for providing the restricting member 101, it is preferable that the restricting member is disposed such that a straight line is formed from the supply port 97 toward an overflow port 99b as shown in Fig. 13. In a case where there is an uneven portion in a liquid interface portion of the restricting member 101, the flow is hindered. In addition, since the restricting member 101 prevents a flow in a liquid interface other than a portion between the overflow ports 99b from the supply port 97 and floating substances are likely to stay, a size that covers the liquid interface which does not form a flow passage is preferable.

In the washout processor 12c, a portion in contact with the resin aggregate is, for example, the gas-liquid interface of the washing solution Q at the developing tank 84. That is, the portion is a portion where the liquid level Qs of the washing solution Q comes into contact with the developing tank 84. In addition, for example, the portion is a gas-liquid interface of the washing solution Q between a side surface 100b of the partition member 100 and a side surface 101b of the restricting member 101. That is, the portion is a portion where the liquid level Qs of the washing solution Q comes into contact with the side surface 100b of the partition member 100 and the side surface 101b of the restricting member 101. In addition, the portion is a gas-liquid interface of the washing solution Q at an inner wall surface of the developing tank 84. That is, the portion is the portion where the liquid level Qs of the washing solution Q comes into contact with the developing tank 84. In addition, the inner wall 25a of the tank 25 (see Fig. 1) is also the portion in contact with the resin aggregate, as in the washout processor 12 described above.

The portion in contact with the resin aggregate is a part of the washout processor in which contact and drying of the washing solution containing the resin aggregate and the washing solution containing the gas-liquid interface of air or the resin aggregate are repeated. In a case where in particular, a part of the developing tank, the rinsing unit, or a drying unit in the washout processor is the portion in contact with the resin aggregate, attachment of the resin aggregate generated as a non-exposed portion of the flexographic printing plate precursor described above is removed through development using the washing solution is suppressed, and an effect in which the resin aggregate can be easily cleaned even in a case of being attached or the like is exhibited.

As described above, a portion in contact with the resin aggregate is composed of polyethylene having a critical surface tension of 31 mN/m or less and a dynamic friction coefficient of 0.2 or less or an average molecular weight of 750,000 to 6,000,000. The portion in contact with the resin aggregate can be configured to have the same composition as that of the washout processor 12 described above.

For this reason, a portion where the liquid level Qs of the washing solution Q comes into contact with the developing tank 84, the side surface 100b of the partition member 100, and the side surface 101b of the restricting member 101 are composed of polyethylene having a critical surface tension of 31 mN/m or less and a dynamic friction coefficient of 0.2 or less or an average molecular weight of 750,000 to 6,000,000. In addition, the portion where the liquid level Qs of the washing solution Q comes into contact with the developing tank 84, the side surface 100b of the partition member 100, and the side surface 101b of the restricting member 101 are composed of, for example, at least one selected from groups consisting of perfluoroalkoxy alkane (PFA), polytetrafluoroethylene (PTFE), and polyethylene having an average molecular weight of 700,000 or more. From a perspective of an abrasion resistance, the portion where the liquid level Qs of the washing solution Q comes into contact with the developing tank 84, the side surface 100b of the partition member 100, and the side surface 101b of the restricting member 101 are composed of polyethylene having an average molecular weight of 750,000 to 6,000,000.

A portion in contact with the resin aggregate, that is, a portion where the liquid level Qs of the washing solution Q comes into contact with the developing tank 84 may have a configuration integrated with the developing tank 84 or may have a separate configuration. For the side surface 100b of the partition member 100 and the side surface 101b of the restricting member 101, the partition member 100 and the restricting member 101 may be formed of polyethylene having a critical surface tension of 31 mN/m or less and a dynamic friction coefficient of 0.2 or less or an average molecular weight of 750,000 to 6,000,000. The side surface 100b of the partition member 100 and the side surface 101b of the restricting member 101 may be formed of polyethylene having a critical surface tension of 31 mN/m or less and a dynamic friction coefficient of 0.2 or less or an average molecular weight of 750,000 to 6,000,000.

### <Washing Method>

A washing method of the washout processor 12c will be described.

First, the plate surface 32a of the flexographic printing plate precursor 32 is imagewise exposed, that is, exposed in a specific pattern by the exposure device (not shown).

In the washout processor 12c, for example, the leading end leader 92 is fixed by being hooked or the like to the fixing units of the pair of transport chains 86 respectively. For example, the trailing end leader 93 is fixed to the fixing units of the transport chains 86 using a magnet. Accordingly, the leading end leader 92 and the trailing end leader 93 are transported in the transport passage by the transporting unit 80.

The leading end of the flexographic printing plate precursor 32 is fixed to the leading end leader 92, and the trailing end is fixed to the trailing end leader 93. In a state where the flexographic printing plate precursor 32 is fixed to the leading end leader 92 and the trailing end leader 93, the turn bar 89a is raised from a lowered state, and a tension is applied to the flexographic printing plate precursor 32. As described above, the flexographic printing plate precursor 32 is fixed to the leader, and a force acts in the direction in which the length of the flexographic printing plate precursor 32 extends in a state where the flexographic printing plate precursor 32 is fixed to the leader. After fixing the flexographic printing plate precursor 32, a tension applied to the flexographic printing plate precursor 32 is made higher than a tension applied to the flexographic printing plate precursor 32 in a case of fixing the flexographic printing plate precursor 32.

Next, the flexographic printing plate precursor 32 is transported along the transport path Dp. In a state where the flexographic printing plate precursor 32 is immersed in the washing solution Q and is transported, the brush 91 of the development unit 81 performs development by removing a non-exposed portion of the flexographic printing plate precursor 32. Since the operations of the brushes 91 are as described above, detailed description thereof will be omitted. In the developing step, the fatiqued developer Qw is generated.

Then, the flexographic printing plate precursor 32 is carried out from the second tank portion M₂ of the developing tank 84. In a state where the flexographic printing plate precursor 32 is transported, a rinsing liquid is applied to the plate surface 32a of the flexographic printing plate precursor 32 by the rinsing unit 82, and residues on the plate surface 32a are removed. In a case of performing development once, at this time point, the fixing of the leading end leader 92 and the trailing end leader 93 is released, and the flexographic printing plate precursor 32 is removed from the leading end leader 92 and the trailing end leader 93. In a case of performing development a plurality of times, the flexographic printing plate precursor 32 is transported by going around, and the flexographic printing plate precursor 32 enters the first tank portion Mi of the developing tank 84 again so that development is performed. Until a predetermined number of times is reached, the developing step and the rinsing step are performed repeatedly. In this case, in at least one of the first tank portion Mi or the second tank portion M₂, preferably the second tank portion M₂, the washing solution Q is flowed in a direction intersecting the width of the flexographic printing plate precursor 32. That is, the washing solution Q is flowed in the direction Fi (see Fig. 13). Accordingly, attachment of solid contents to the plate surface 32a of the flexographic printing plate precursor 32 is suppressed.

In a case where the flexographic printing plate precursor 32 goes around a plurality of times, even in a state where the attachment of the solid contents to the plate surface 32a of the flexographic printing plate precursor 32 is suppressed in the second tank portion M₂, a probability of the solid contents being attached to the flexographic printing plate precursor 32 is high in a case where the solid contents float on the liquid level of the first tank portion Mi. For this reason, it is preferable to flow the washing solution Q in the direction Fi (see Fig. 13) in both the first tank portion Mi and the second tank portion M₂.

In addition, in the washout processor 12c, even in a case where the concentration of solid contents in the washing solution Q of the developing tank is 6.3%, the solid contents are not attached to the flexographic printing plate precursor 32. Further, in this state, in a case where development treatment is continued, an aggregate on the liquid level Qs of the washing solution Q is efficiently removed by the filter 59 provided at the overflow port 99b. For this reason, the concentration of the solid contents in the washing solution Q has decreased, for example, from 6.3% to 4.8%. The filter 59 of the overflow port 99b is recognized to have effects such as reducing a load on the filter 27 provided at a discharge destination of the pump 26 and lowering the concentration of the solid contents and a resin aggregate dispersed in the washing solution Q.

By setting the transport path Dp that goes around the vicinity of the frame 83 as in the washout processor 12c, a provision area can be decreased compared to a transport path through which the flexographic printing plate precursor 32 is transported in one direction.

By changing the sizes of the member 83a and the beam member 83b of the frame 83, it is possible to correspond to the size of the flexographic printing plate precursor 32. Even in a case where the flexographic printing plate precursor 32 is large, the configuration of the washout processor 12c does not become complicated.

Further, by making the frame 83 in an upright state as shown in Fig. 10 and configuring the flexographic printing plate precursor 32 to be transported perpendicularly to the liquid level of the washing solution Q in the developing tank 84, a grounding area can be decreased compared to a state where the frame 83 is rotated 90° from the state shown in Fig. 10, and the space can be saved. In addition, even in a case where the transport path Dp is long, without increasing the washout processor 12c in size, the grounding area can be decreased, and the space can be saved. In a state where the frame 83 is rotated 90° from the state shown in Fig. 10, in a case of development, it is necessary to increase a region immersed in the washing solution Q, and it is necessary to increase the developing tank 84 as well. However, even in a state where the frame 83 is rotated 90° from the state shown in Fig. 10, the volume of the washout processor 12c is small. For this reason, the washout processor 12c has a small apparatus configuration regardless of the disposition state of the frame 83, and the space can be saved.

In addition, transporting the flexographic printing plate precursor 32 perpendicularly to the liquid level of the washing solution Q in the developing tank 84 is referred to as vertical transport.

Further, a configuration of being removed from pins 62d and 63d and not being buckled in a case of removing the flexographic printing plate precursor 32 from the leading end leader 92 and the trailing end leader 93 is adopted. In addition, since an adhesive layer is not used even in a case where the flexographic printing plate precursor 32 is immersed in the washing solution Q, processing such as development can be stably performed on the flexographic printing plate precursor without being detached.

In a state where the flexographic printing plate precursor 32 is fixed to the leading end leader 92 and the trailing end leader 93 and a tension is applied by the tension applying unit, development is performed using the washing solution while transporting the flexographic printing plate precursor. For this reason, fluctuations in the tension of the flexographic printing plate precursor 32 are suppressed, development treatment can be performed in a state where the tension is stable, and processing such as development can be stably performed on the flexographic printing plate precursor 32.

By providing the leader mechanism portion that expands and contracts in the traveling direction of the flexographic printing plate precursor 32, development treatment can be performed in a state where a tension is more stable. Accordingly, processing such as development can be more stably performed on the flexographic printing plate precursor.

In the washout processor 12c, the flexographic printing plate precursor 32 is transported using the transport chain 86, and maintainability is excellent without having a complicated apparatus configuration.

In addition, by performing the developing step in a state where the flexographic printing plate precursor 32 is being transported, the brush can be decreased in size, and washing productivity can be improved. It is necessary for the method of the related art in which the printing plate is fixed and only a brush is movable to prepare the brush having a wide area corresponding to the size of the printing plate, to increase the number of brushes in a case of using a small brush, or to increase an operating range of the brush. In a case where the printing plate precursor is transported, even the small brush can obtain the same processing capacity. Further, it is possible to provide more brushes in the linear transport passage Dps in a treatment liquid (not shown) and the curved transport passage Dpc (turn portion), it is possible to increase the transportation speed of the printing plate precursor since a processing time is shortened by an increase in the number of brushes, and the productivity of the washout processor 12c increases.

In addition, by developing the flexographic printing plate precursor 32 in the washing solution Q, fixing of development residues to the brush 91 is suppressed, and the frequency of maintenance can be decreased. Accordingly, a maintenance load can be decreased, and the washout processor 12c is excellent in maintainability.

Since the frequency of maintenance can be decreased, for example, monthly average or annual average development treatment can be increased, and the washout processor 12c has high productivity from this point as well.

As described above, even in a state where the washing solution has a large amount of solid contents, that is, there is a large amount of resin aggregate in the washing solution, development treatment can be performed without attachment of residues to the flexographic printing plate precursor 32. As a result, the amount of a replenishment liquid such as tap water and a detergent replenishment diluent can be reduced, the number of times of mother liquor exchange can be reduced, and a washout processor with a small environmental load with reduced total waste can be realized.

As a relationship between the concentration of the solid contents and the waste liquid amount of a developer, the waste liquid amount is reduced, and thus running costs are reduced in a case where attachment of residues does not occur even at a high concentration of the solid contents.

For example, the concentration of the solid contents of the developing tank during development treatment, in which 0.5% dishwasher detergent finish is used, replenishment water is 7.0 L/m², and a scraping amount of the non-exposed portion of the flexographic printing plate precursor is 450 g/m², becomes 5.8% (the concentration of the solid contents is 6.3% including detergent solid contents). Further, even in a case where the residues are 11.5% (12.0% including the detergent solid contents) and can be prevented from being attached to the flexographic printing plate precursor, the amount of the replenishment water can be reduced to 3.3 L/m². Accordingly, 3.7 L/m² of waste liquid can be reduced, and reduction of an environmental load and reduction of running costs can be realized.

On the other hand, in a case where the concentration of the solid contents exceeds 5.0% (the concentration of the solid contents is 5.5% including the detergent solid contents) and a state where the residues are attached to the flexographic printing plate precursor on which development treatment is performed is caused, it is necessary to entirely replace the liquid of the developing tank with a new liquid and to perform cleaning, and a total waste amount significantly increases, but such a situation does not occur in the washout processor.

Since the washout processor 12c is provided with the partition member 100 and the restricting member 101, a decrease in the flow rate of the washing solution Q can be suppressed, and the solid contents are more unlikely to be attached to the plate surface 32a of the developed flexographic printing plate precursor 32.

In the washing method, a used washing solution from which the resin aggregate is removed using the regeneration treatment apparatus 14 is also used.

In the washing method, a timing when the resin aggregate is removed by the regeneration treatment apparatus 14 is, for example, a case where the concentration of solid contents of the washing solution Q in the tank 25 exceeds a set concentration or a case where a treatment area of the flexographic printing plate precursor 32 exceeds a set treatment area. The used washing solution in the tank 25 is supplied to the rotating body 36 of the regeneration treatment apparatus 14 by the pump 16, as in the first example of the regeneration treatment method described above, the resin aggregate is removed from the used washing solution, and the used washing solution from which the resin aggregate is removed is transferred to the tank 25 through the pipe 15b.

Although the washout processor 12c may have a configuration where the regeneration treatment apparatus 14 is connected to the tank 25, the present invention is not limited thereto. For example, the waste liquid tank 95 and the regeneration treatment apparatus 14 may be connected to each other, the fatiqued developer Qw may be supplied to the regeneration treatment apparatus 14, and the resin aggregate 17 may be removed from the fatiqued developer Qw as described above and be reused as the washing solution.

Hereinafter, the flexographic printing plate precursor will be described.

### (Flexographic Printing Plate Precursor)

The flexographic printing plate precursor 32 has a photosensitive resin layer.

The flexographic printing plate precursor 32 forms a flexographic printing plate used in flexographic printing, and the configuration thereof is not particularly limited. The flexographic printing plate precursor 32 is as thin as several millimeters and has flexibility. Having flexibility means returning from a bent state caused by an acting force to the original state after unloading the force. The size of the flexographic printing plate precursor 32 is, for example, 800 mm × 1,200 mm, and 1,050 mm × 1,500 mm.

It is preferable that the flexographic printing plate precursor 32 is a flexographic printing plate precursor that can be developed with a water-based washing solution of which a main component is water and a flexographic printing plate precursor that is called a water-developing type flexographic printing plate precursor. In this case, the washing solution is the water-based washing solution.

A known flexographic printing plate precursor that can be developed with the water-based washing solution is usable as the flexographic printing plate precursor 32, and examples of the flexographic printing plate precursor 32 include a flexographic plate material for computer to plate (CTP) having a surface to which a black layer is coated. The black layer configures a black mask.

Hereinafter, the washing solution will be described.

### <Washing Solution>

The washing solution is a water-based washing solution and has water as a main component. Having water as a main component means a water content is 90% by mass or more.

The washing solution may be a solution consisting of only water and may be an aqueous solution which contains 50% by mass or more of water and to which a water soluble compound is added. Examples of the water soluble compound include surfactants, acids, and alkaline agents. The washing solution also contains chelating agents. The water-based washing solution described above corresponds to the water-based washing solution.

Examples of the surfactant include anionic surfactants, nonionic surfactants, cationic surfactants, and amphoteric surfactants, and among the surfactants, anionic surfactants are preferable.

Specific examples of the anionic surfactant include aliphatic carboxylates such as sodium laurate and sodium oleate; higher alcohol sulfate ester salts such as sodium lauryl sulfate, sodium cetyl sulfate, and sodium oleyl sulfate; polyoxyethylene alkyl ether sulfates such as sodium polyoxyethylene lauryl ether sulfate; polyoxyethylene alkyl allyl ether sulfates such as sodium polyoxyethylene octylphenyl ether sulfate and sodium polyoxyethylene nonylphenyl ether sulfate; alkyl sulfonates such as alkyldiphenyl ether disulfonate, sodium dodecyl sulfonate, and sodium dialkyl sulfosuccinate; alkyl allyl sulfonates such as alkyl disulfonate, sodium dodecylbenzene sulfonate, sodium dibutylnaphthalene sulfonate, and sodium triisopropylnaphthalene sulfonate; higher alcohol phosphate ester salts such as lauryl phosphate monoester disodium and sodium lauryl phosphate diester; polyoxyethylene alkyl ether phosphoric acid ester salts such as polyoxyethylene lauryl ether phosphoric acid monoester disodium and polyoxyethylene lauryl ether phosphoric acid diester sodium. These may be used alone or may be used in combination of two or more types. Although a sodium salt is given as a specific example, it is not particularly limited to the sodium salt, and the same effect can be obtained with a calcium salt, an ammonia salt, or the like.

Specific examples of the nonionic surfactant include polyoxyethylene alkyl ethers such as polyoxyethylene oleyl ether and polyoxyethylene lauryl ether, polyoxyethylene polyoxypropylene glycols including polyoxyethylene alkyl phenyl ethers such as polyoxyethylene nonylphenyl ether and polyoxyethylene octylphenyl ether, mono and diesters of polyethylene glycol and fatty acids such as polyethylene glycol monostearate, polyethylene glycol monooleate, and polyethylene glycol dilaurate, fatty acids and sorbitan esters such as sorbitan monolaurate and sorbitan monooleate, esters of sorbitan polyoxyethylene adducts and fatty acids such as polyoxyethylene sorbitan monolaurate, polyoxyethylene sorbitan monostearate, and polyoxyethylene sorbitan trilaurate, esters fatty acids and sorbitol such as sorbitol monopalmitate and sorbitol dilaurate, esters of sorbitol polyoxyethylene adducts and fatty acids such as polyoxyethylene sorbitol monostearate and polyoxyethylene sorbitol diolate, esters of fatty acids and pentaerythritol such as pentaerythritol monostearate, esters of fatty acids and glycerin such as glycerin monolaurate, fatty acid alkanolamides such as lauric acid diethanolamide and lauric acid monoethanolamide, amine oxides such as lauryl dimethylamine oxide, fatty acid alkanolamines such as stearyl diethanolamine, polyoxyethylene alkylamines, triethanolamine fatty acid esters, alkaline salt compounds such as phosphates, carbonates, and silicates. These may be used alone or may be used in combination of two or more types.

Specific examples of the cationic surfactant include primary, secondary and tertiary amine salts such as monostearylammonium chloride, distearylammonium chloride, and tristearylammonium chloride, quaternary ammonium salts such as stearyltrimethylammoum chloride, distearyldimethylammonium chloride, and stearyldimethylbenzylammonium chloride, alkylpyridinium salts such as N-cetylpyridinium chloride and N-stearylpyridinium chloride, N, N dialkyl morpholinium salts, fatty acid amide salts of polyethylene polyamines, acetic acids of urea compounds of amides of aminoethylethanolamine and stearic acid, and 2-alkyl-1-hydroxyethylimidazolinium chloride. These may be used alone or may be used in combination of two or more types.

Specific examples of the amphoteric surfactant include amino acid types such as sodium laurylamine propionate, carboxybetaine types such as lauryldimethylbetaine and lauryldihydroxyethylbetaine, sulfobetaine types such as stearyldimethylsulfoethyleneammonium betaine, imidazolenium betaine types, and lecithin. These may be used alone or may be used in combination of two or more types.

Specific examples of the acid include inorganic acids or organic acids such as hydrochloric acid, sulfuric acid, nitric acid, phosphoric acid, formic acid, acetic acid, oxalic acid, succinic acid, citric acid, malic acid, maleic acid, and paratoluenesulfonic acid.

Specific examples of the alkaline agent include lithium hydroxide, sodium hydroxide, magnesium hydroxide, potassium hydroxide, calcium hydroxide, calcium oxide, sodium carbonate, sodium hydrogencarbonate, and calcium carbonate.

Specific examples of the chelating agent, that is, a metal blocking agent, include citric acid, ethylenediaminetetraacetic acid (EDTA), ethylenediamine-N, N'-disuccinic acid (EDDS), L-glutamic acid N,N-diacetic acid (GLDA), and alkali metal salt.

Hereinafter, the fatiqued developer will be described in detail.

### <Fatiqued Developer>

The fatiqued developer is a washing solution used in development and is a used washing solution. The fatiqued developer is not particularly limited insofar as the fatiqued developer is a washing solution containing solid contents generated by removing the non-exposed portion of the flexographic printing plate precursor due to development using the washing solution described above, that is, a washing solution containing a resin aggregate in which solid contents or the like are aggregated. However, a fatiqued developer containing a known photosensitive resin composition of the related art for forming a general photosensitive resin layer may be included.

An uncured resin caused by a non-exposed portion removed through development may be a photosensitive resin contained in the photosensitive resin composition.

In addition, since it is preferable to set a fatiqued developer in a case of developing under a laser ablation masking (LAM) method as a processing target, it is preferable that the uncured resin removed through development is the photosensitive resin contained in the photosensitive resin composition.

In addition, since examples of such a photosensitive resin composition include a composition containing a polymerization initiator, a polymerizable compound, a polymerization inhibitor, and a plasticizer, in addition to the photosensitive resin, the fatiqued developer may contain a polymerization initiator, a polymerizable compound, a polymerization inhibitor, a plasticizer, and the like, in addition to the uncured resin.

### <Uncured Resin>

The uncured resin contained in the fatiqued developer is solid contents generated by removing a non-exposed portion of the flexographic printing plate precursor. The solid contents are sensitizer components dispersed in the washing solution described above.

Examples of the uncured resin contained in the fatiqued developer include water-dispersible latex, rubber components, polymer components, and uncrosslinked ethylenically unsaturated compounds (polymers).

Examples of the water-dispersible latex include water-dispersed latex polymers including water-dispersed latex such as polybutadiene latex, natural rubber latex, styrene-butadiene copolymer latex, acrylonitrile-butadiene copolymer latex, polychloroprene latex, polyisoprene latex, polyurethane latex, methyl methacrylate-butadiene copolymer latex, vinyl pyridine copolymer latex, butyl polymer latex, thiocol polymer latex, and acrylate polymer latex and polymers obtained by copolymerizing these polymers with other components such as acrylic acid or methacrylic acid.

Examples of the rubber component include butadiene rubber, isoprene rubber, styrene-butadiene rubber, acrylonitrile rubber, acrylonitrile butadiene rubber, chloroprene rubber, polyurethane rubber, silicon rubber, butyl rubber, ethylene-propylene rubber, and epichlorohydrin rubber.

The polymer component may be hydrophilic or may be hydrophobic, and specific examples thereof include a polyamide resin, an unsaturated polyester resin, an acrylic resin, a polyurethane resin, a polyester resin, and polyvinyl alcohol resin.

The solid contents having a specific gravity lower than the washing solution are, for example, photosensitive resins such as rubber components and latex.

The solid contents having a specific gravity higher than the washing solution are, for example, components of overcoat layers such as carbon.

Examples of the ethylenically unsaturated compound (polymer) include (meth) acrylic modified polymers having an ethylenically unsaturated bond in the molecule.

Examples of the (meth) acrylic modified polymer include (meth) acrylic modified butadiene rubber and (meth) acrylic modified nitrile rubber.

"(Meth) acrylic" is a notation representing acrylic or methacrylic, and "(meth) acrylate" to be described later is a notation representing acrylate or methacrylate.

The uncured resin contained in the fatiqued developer is not particularly limited, but is preferably 70% by mass or less, and more preferably 35% by mass or less.

### <Polymerization Initiator>

The polymerization initiator that may be contained in the fatiqued developer is preferably a photopolymerization initiator.

Examples of the photopolymerization initiator described above include alkylphenones, acetophenones, benzoin ethers, benzophenones, thioxanthones, anthraquinones, benzyls, and biacetyls, and among them, alkylphenones are preferable.

Specific examples of the alkylphenones photopolymerization initiators include 2,2-dimethoxy-1,2-diphenylethane-1-one, 1-hydroxy-cyclohexyl-phenyl-ketone, and 2-hydroxy-2-methyl-1-phenyl-propane-1-one.

The concentration of the polymerization initiator that may be contained in the fatiqued developer is not particularly limited, but is preferably 2.0% by mass or less, and more preferably 1.0% by mass or less.

### <Polymerizable Compound>

Examples of the polymerizable compound that may be contained in the fatiqued developer include ethylenically unsaturated compounds that correspond to so-called monomer components other than the ethylenically unsaturated compounds (polymers) described above.

The ethylenically unsaturated compound may be a compound having one ethylenically unsaturated bond or may be a compound having two or more ethylenically unsaturated bonds.

Specific examples of the compound having one ethylenically unsaturated bond include (meth) acrylate having a hydroxyl group such as 2-hydroxyethyl (meth) acrylate, 2-hydroxypropyl (meth) acrylate, 2-hydroxybutyl (meth) acrylate, 3-chloro-2-hydroxypropyl (meth) acrylate, and β-hydroxy-β'-(meth) acryloyloxyethyl phthalate; alkyl (meth) acrylates such as methyl (meth) acrylate, ethyl (meth) acrylate, propyl (meth) acrylate, butyl (meth) acrylate, isoamyl (meth) acrylate, 2-ethylhexyl (meth) acrylate, lauryl (meth) acrylate, and stearyl (meth) acrylate; cycloalkyl (meth) acrylates such as cyclohexyl (meth) acrylate; alkyl halogenated (meth) acrylates such as chloroethyl (meth) acrylate and chloropropyl (meth) acrylate; alkoxyalkyl (meth) acrylates such as methoxyethyl (meth) acrylate, ethoxyethyl (meth) acrylate, and butoxyethyl (meth) acrylate; phenoxyalkyl (meth) acrylates such as phenoxyethyl (meth) acrylate and nonylphenoxyethyl (meth) acrylate; alkoxyalkylene glycol (meth) acrylates such as ethoxydiethylene glycol (meth) acrylate, methoxytriethylene glycol (meth) acrylate, and methoxydipropylene glycol (meth) acrylate; 2,2-dimethylaminoethyl (meth) acrylate, 2,2-diethylaminoethyl (meth) acrylate, 2-hydroxyethyl (meth) acrylate, and 3-chloro-2-hydroxypropyl (meth) acrylate.

Specific examples of the ethylenically unsaturated compound having two or more ethylenically unsaturated bonds include alkyldiol di (meth) acrylates such as 1,9-nonane diol di (meth) acrylate; polyethylene glycol di (meth) acrylates such as diethylene glycol di (meth) acrylate; polypropylene glycol di (meth) acrylates such as dipropylene glycol di (meth) acrylate; polyvalent (meth) acrylates obtained by addition reaction of a compound having an ethylenically unsaturated bond, such as unsaturated carboxylic acid and unsaturated alcohol, and active hydrogen with trimethylolpropane tri (meth) acrylate, pentaerythritol tri (meth) acrylate, pentaerythritol tetra (meth) acrylate, glycerol tri (meth) acrylate, and ethylene glycol diglycidyl ether; polyvalent (meth) acrylates obtained by addition reaction of an unsaturated epoxy compound such as glycidyl (meth) acrylate with a compound having active hydrogen such as carboxylic acid and amine; polyvalent (meth) acrylamides such as methylenebis (meth) acrylamide; polyvalent vinyl compounds such as divinylbenzene.

The concentration of the polymerizable compound that may be contained in the fatiqued developer is not particularly limited, but is preferably 30.0% by mass or less, and more preferably 15.0% by mass or less.

### <Polymerization Inhibitor>

Specific examples of the polymerization inhibitor that may be contained in the fatiqued developer include hydroquinone monomethyl ether, p-methoxyphenol, di-t-butyl-p-cresol, pyrogallol, t-butylcatechol, benzoquinone, 4,4'-thiobis (3-methyl-6-t-butylphenol), 2,2'-methylenebis (4-methyl-6-t-butylphenol), and N-nitrosophenylhydroxyamine cerous salt.

The concentration of the polymerization inhibitor that may be contained in the fatiqued developer is not particularly limited, but is preferably 0.3% by mass or less, and more preferably 0.15% by mass or less.

### <Plasticizer>

Examples of the plasticizer that may be contained in the fatiqued developer include liquid rubber, oil, polyester, and phosphoric acid-based compounds.

Specific examples of the liquid rubber include liquid polybutadiene, liquid polyisoprene, and those modified with maleic acid or an epoxy group.

Specific examples of the oil include paraffin oil, naphthenic oil, and aroma oil.

Specific examples of the polyester include adipic acid-based polyester.

Specific examples of the phosphoric acid-based compound include phosphoric acid ester.

The concentration of the plasticizer that may be contained in the fatiqued developer is not particularly limited, but is preferably 30% by mass or less, and more preferably 15% by mass or less.

The present invention is basically configured as described above. Although the regeneration treatment apparatus, the washout processor, and the manufacturing method of a flexographic printing plate according to the embodiment of the present invention have been described in detail hereinbefore, the present invention is not limited to the embodiment described above, and it is evident that various improvements or changes may be made without departing from the gist of the present invention.

### Examples

Hereinafter, characteristics of the present invention will be described in further detail with reference to examples. The materials, reagents, amounts and ratios of substances, operations, and the like shown in the following examples can be appropriately changed without departing from the spirit of the present invention. Therefore, the scope of the present invention is not limited to the following examples.

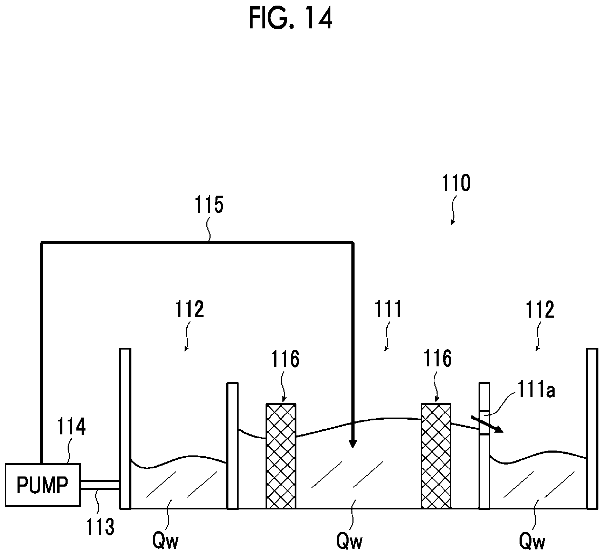

In the present example, examples 1 to 3 and comparative examples 1 to 6 were evaluated for residue attachability and cleanability using an evaluation device 110 shown in Fig. 14.

Hereinafter, the evaluation device 110 will be described. Fig. 14 is a schematic view showing the evaluation device using the examples of the present invention.

The evaluation device 110 shown in Fig. 14 has an inner tank 111 and an outer tank 112 surrounding the inner tank 111. An opening portion 111a is formed in a part of the inner tank 111, and the fatiqued developer Qw in the inner tank 111 overflows from the opening portion 111a and flows out to the outer tank 112. A pipe 113 is provided at the outer tank 112, and a pump 114 is connected to the pipe 113. The pump 114 is connected to a pipe 115 that reaches the inner tank 111. The fatiqued developer Qw in the outer tank 112 is supplied to the inner tank 111 through the pipe 115 by the pump 114. In addition, an evaluation sample 116 is disposed in the inner tank 111.

Evaluation for residue attachability and cleanability was performed as follows using the evaluation device 110.
(1) A pump was operated for 1 minute, and a liquid level came into contact with the fatiqued developer Qw from the opening portion 111a of an overflow to a height of 1 cm.

Next, (2) the pump was stopped for 5 minutes, during which the liquid level is lowered to the height of the overflow, and drying in air was performed again in a portion having a width of 1 cm.

(1) and (2) described above were repeated 1,000 times, and contact with the fatiqued developer and drying in air were repeated in the portion having the width of 1 cm described above.

After repeating 1,000 times as described above, evaluation for presence or absence of an attachment in the portion having the width of 1 cm and cleanability thereof in a case where there is the attachment was made.

### <Fatiqued Developer>

A washing solution having a concentration of solid contents of 11.1% was used as the fatiqued developer. An aqueous solution of Finish Power & Pure Powder SP (manufactured by Reckitt Benckiser Japan Ltd.) was used as the washing solution.

The fatiqued developer was subjected to quantitative sampling, was dried and solidified in an oven at a temperature of 95°C for 24 hours, was taken out from the oven, was cooled at room temperature for 5 minutes, and then was measured by mass, and the concentration of the solid contents was calculated from the mass before and after drying. The concentration of the solid contents corresponds to the concentration of a resin aggregate.

### [Evaluation for Residue Attachability]

Regarding residue attachability, the presence or absence of an attachment to the evaluation sample was visually checked. A was given in a case where there is no attachment, and B was given in a case where there is an attachment. Table 1 shows the results.

### [Evaluation for Cleanability]

In a case where an attachment to the evaluation sample was peeled off by lightly rubbing back and forth 1 to 2 times with a finger with a protective glove, A was given for cleanability. In a case where the attachment was peeled off only after rubbing back and forth 3 or more times with the finger with the protective glove, B was given. Table 1 shows the results.

Hereinafter, examples 1 to 3 and comparative examples 1 to 6 will be described.

### (Example 1)

In example 1, the evaluation sample was formed of polytetrafluoroethylene (PTFE).

Specifically, the evaluation sample was formed of PTFE 807NX manufactured by Chemours-Mitsui Fluoroproducts Co., Ltd.

In example 1, a critical surface tension was 18 mN/m, and a dynamic friction coefficient was 0.1.

A critical surface tension was measured based on "JIS K6768 Plastics - Film and sheeting - Determination of wetting tension" using a mixed solution for wetting surface tension test manufactured by FUJIFILM Wako Pure Chemical Corporation.

Specifically, a mixed solution for test was added dropwise onto a test piece, and immediately the mixed solution for test was spread using a wire bar, a cotton swab, or a brush. A liquid amount which was enough to form a thin layer without creating accumulation was set. Determination was made in a state of a central portion of the liquid film immediately before a timing of moment when two seconds had elapsed after reagents were coated. In a case where the original state was maintained without occurrence of breakage, it was determined that the coated liquid film was "wet", and in a case where breakage had occurred, it was determined that the coated liquid film was "not wet". This operation was repeated at least three times, and a mixed solution that could make the surface of the test piece wet for accurately two seconds was selected. The surface tension of the selected mixed solution was a wetting tension of a solid. For example, a surface tension (critical surface tension) in a case where a reagent that is determined to be "wet" with a 31.0 mN/m mixed solution for wetting tension test (reagent) or that has a different surface tension is added dropwise to measure a contact angle, the surface tension of the reagent versus a contact angle (cosθ) is plotted, and an approximate straight line is extrapolated to cosθ = 1 (zero contact angle) is 31 mN/m or less. The contact angle was measured using a contact angle meter of Kyowa Interface Science Co., Ltd. A known Zisman critical surface tension is shown through a measuring method in which a surface tension in a case where a reagent that has a different surface tension is added dropwise to measure a contact angle, the surface tension of the reagent versus a contact angle (cosθ) is plotted, and an approximate straight line is extrapolated to cosθ = 1 (zero contact angle) is used as a critical surface tension, and which is a method called the Zisman plot.

The dynamic friction coefficient was measured by assembling a test device formed of a tension-tester (Autograph of Shimadzu Corporation) (according to JIS K7125) and using a stainless steel plate (an SUS 304 plate as a mating material), in which an induction path made of stainless steel was assumed, on a test table.

An environment in a case of measuring both the critical surface tension and the dynamic friction coefficient was a normal temperature (20°C to 25°C).

### (Example 2)

In example 2, the evaluation sample was formed of perfluoroalkoxy alkane (PFA). Specifically, the evaluation sample was formed of PFA 451HP-J manufactured by Chemours-Mitsui Fluoroproducts Co., Ltd.

In example 2, a critical surface tension was 18 mN/m, and a dynamic friction coefficient was 0.2.

### (Example 3)

In example 3, the evaluation sample was formed of ultra high molecular weight polyethylene.

Specifically, the evaluation sample was formed of ultra high molecular weight polyethylene film tape No. 440 (product number) manufactured by Nitto Denko Corporation.

In example 3, a critical surface tension was 31 mN/m, and a dynamic friction coefficient was 0.2.

### (Comparative Example 1)

In comparative example 1, the evaluation sample was formed of a copolymer of tetrafluoroethylene and hexafluoropropylene (FEP). Specifically, the evaluation sample was formed of FEP 100X manufactured by Chemours-Mitsui Fluoroproducts Co., Ltd.

In comparative example 1, a critical surface tension was 18 mN/m, and a dynamic friction coefficient was 0.3.

### (Comparative Example 2)

In comparative example 2, the evaluation sample was formed of MC nylon (registered trademark). Specifically, the evaluation sample was formed of MC901 manufactured by Mitsubishi Chemical Advanced Materials Inc.

In comparative example 2, a critical surface tension was 41 mN/m, and a dynamic friction coefficient was 0.15.

### (Comparative Example 3)

In comparative example 3, the evaluation sample was formed of an SUS304 plate.

In comparative example 3, a critical surface tension was 36 mN/m, and a dynamic friction coefficient was 0.53.

Since a metal oxide was formed on the surface of a metal exposed to the air, chemically adsorbed water molecules were present on the surface of the metal oxide, and water in a multi-molecular layer hydrogen-bonded thereto was physically adsorbed, variations occurred in the critical surface tension measured by the humidity of the environment, but did not become 36 mN/m or less.

The surface had become a high-energy surface having a surface free energy per unit area of the actual metal surface, which did not cause passivation or was not oxidized, of 500 mJ/m² or more (= surface tension of 500 mN/m or more). On the other hand, the surface free energy of the plastics showed a low value. Since a polymer material hardly adsorbed water and there was no change in the material surface due to environmental substances, the critical surface tension showed a value close to the critical surface tension of Zisman. Regarding stainless steel and aluminum, not only the critical surface tension of a pure metal itself was measured but also the metal surface covered with an oxide or an adsorbent was measured under the influence of air or moisture. Chrome contained in stainless steel was bonded to oxygen on the surface to form passivation. On the other hand, in PTFE, PFA, and ultra high molecular weight polyethylene, in which a material surface was not adsorbed or oxidized by environmental substances, the originally low critical surface tension could be maintained.

### (Comparative Example 4)

In comparative example 4, the evaluation sample was formed of an aluminum plate.

The aluminum plate was formed of A5052 based on JIS H4000:2006.

In comparative example 4, a critical surface tension was 37 mN/m, and a dynamic friction coefficient was 0.34.

### (Comparative Example 5)

In comparative example 5, the evaluation sample was formed of a hard vinyl chloride plate.

The hard vinyl chloride plate was formed of product name Hishi Plate, which is a PVC plate (for general industrial use) of Mitsubishi Chemical Infratec Co., Ltd.

In comparative example 5, a critical surface tension was 39 mN/m, and a dynamic friction coefficient was 0.25.

### (Comparative Example 6)

In comparative example 6, the evaluation sample was formed of an acrylic resin plate.

The acrylic resin plate was formed of product name Shinkolite.

In comparative example 6, a critical surface tension was 39 mN/m, and a dynamic friction coefficient was 0.48.

**[Table 1]**

| | Physical property | | Evaluation | |
|---|---|---|---|---|
| | Critical surface tension (mN/m) | Dynamic friction coefficient | Residue attachability | Cleanability |
| Example 1 | 18 | 0.1 | A | A |
| Example 2 | 18 | 0.2 | A | A |
| Example 3 | 31 | 0.2 | B | A |
| Comparative Example 1 | 18.5 | 0.3 | B | B |
| Comparative Example 2 | 41 | 0.15 | B | B |
| Comparative Example 3 | 36 | 0.53 | B | B |
| Comparative Example 4 | 37 | 0.34 | B | B |
| Comparative Example 5 | 39 | 0.25 | B | B |
| Comparative Example 6 | 39 | 0.48 | B | B |

As shown in table 1, examples 1 and 2 were excellent in terms of residue attachability and cleanability compared to comparative examples 1 to 6.

In example 3, there was an attachment, but the attachment could be easily peeled off.

In comparative examples 1 to 6, none of ranges of the critical surface tension and the dynamic friction coefficient were satisfied, and there was an attachment. Further, the attachment could not be easily peeled off.

Among examples 1 to 3, processing was easily performed in example 3, example 2, and example 1 in this order. That is, processing was most easily performed in example 3, and processing forming was excellent.

In addition, a scratch resistance was most excellent in example 3 among examples 1 to 3. That is, in a case where the attachment was rubbed for peeling off, scratches are unlikely to be made.

As described above, among examples 1 to 3, example 1 (PTFE) and example 2 (PFA) were excellent in that attachment of an aggregate itself can be suppressed. In example 3 (ultra high molecular weight polyethylene), the attachment was generated but was easily peeled off. Further, example 3 was excellent in that processing forming was easily performed and in that a scratch resistance was strong.

### Explanation of References

10: treatment system
12, 12a, 12b, 12c: washout processor
14: regeneration treatment apparatus
15a, 15b: pipe
16: pump
17: resin aggregate
20: developing tank
20a: opening
20b: lower surface
20d: portion
21: pipe 28 pipe
22: developing brush
22a: substrate
22b: bristle
22c: rotation shaft
24: rinsing unit
25: tank
25a: inner wall
26: pump
27, 59: filter
29a, 44, 71: brush
29b: supply port
30: support plate
31: centrifuge
32: flexographic printing plate precursor
32a: plate surface
32b: back surface
32c: leading end
33: induction path
33a: inner portion
34: base
35: case
36: rotating body
36a: opening portion
36b: trunk portion
36c: inclined part
36d: bottom portion
36e: inner wall
37: shutter
38a: inside disk
38b: separation plate
39: scraper
40: collection container
42: developing tank
42b: bottom surface
42c, 42d, 42e: side surface
42f: side surface
42g: inner wall surface
42h: portion
43: lid
43b: back surface
44, 71: brush
44a: substrate
44b: bristle
45a: supply port
45b: blowout port
46a: output port
46b: suction port
49: heater
50: first valve
50b: fifth valve
51, 53, 55, 57: pipe
52: second valve
54: third valve
56: fourth valve
58: liquid feeding port
60: motor
62: crank
64: fixing member
65: support plate
66a: pipe
67: flow creation unit
67a: first flow creation unit
67b: second flow creation unit
68, 70: development unit
72: transport roller
73: connecting pipe
74: replenishment pump
75: replenishment tank
76: support body
77: rinsing unit
77a: rinsing liquid supply unit
77b: liquid drain nozzle
80: transporting unit
81: development unit
82: rinsing unit
82a: rinsing liquid supply unit
82b: liquid drain nozzle
83: frame
83a: member
83b: beam member
84: developing tank
84b: bottom surface
84c, 84d: side surface
84g: space
85: gear
85a: shaft
86: transport chain
87: transport driving unit
88: tension adjusting unit
89a, 89b: turn bar
90: back plate portion
91: brush
91a: rotation shaft portion
92: leading end leader
93: trailing end leader
95: waste liquid tank
95a: connecting pipe
96, 97: supply port
96b, 97a, 97b: pipe
98: circulation pump
99b: overflow port
100: partition member
100a: end part
100b, 101b: side surface
101: restricting member
110: evaluation device
111: inner tank
111a: opening portion
112: outer tank
113, 115: pipe
114: pump
116: evaluation sample
C: rotation axis
D: transport direction
Di: first region
D₂: second region
D_{L}: traveling direction
Di: carry-in direction
Dp: transport path
Dpc, Dps: transport passage
Dw: direction
Fi: direction
M₁: first tank portion
M₂: second tank portion
Mb: swing width
Q: washing solution
Qs: liquid level
Qw: fatiqued developer
r: rotation direction

## Claims

1. A regeneration treatment apparatus that from a used washing solution containing a resin aggregate generated as a non-exposed portion of an imagewise exposed flexographic printing plate precursor having a photosensitive resin layer is removed through development using a washing solution of which a main component is water, removes the resin aggregate, the regeneration treatment apparatus comprising:
a centrifuge that has a rotating body for separating out the resin aggregate from the used washing solution; and
an induction path through which the resin aggregate from the centrifuge passes,
wherein a portion in contact with the resin aggregate has a critical surface tension of 31 mN/m or less and a dynamic friction coefficient of 0.2 or less.

2. The regeneration treatment apparatus according to claim 1,
wherein the portion in contact with the resin aggregate is a portion in contact with the resin aggregate once or repeatedly.

3. The regeneration treatment apparatus according to claim 1 or 2,
wherein the portion in contact with the resin aggregate is the induction path.

4. The regeneration treatment apparatus according to any one of claims 1 to 3,
wherein the portion in contact with the resin aggregate is composed of at least one selected from groups consisting of perfluoroalkoxy alkane, polytetrafluoroethylene, and polyethylene having an average molecular weight of 700,000 or more.

5. The regeneration treatment apparatus according to any one of claims 1 to 3,
wherein the portion in contact with the resin aggregate is composed of polyethylene having an average molecular weight of 750,000 to 6,000,000.

6. A regeneration treatment apparatus that from a used washing solution containing a resin aggregate generated as a non-exposed portion of an imagewise exposed flexographic printing plate precursor having a photosensitive resin layer is removed through development using a washing solution of which a main component is water, removes the resin aggregate,
wherein a portion in contact with the resin aggregate is composed of polyethylene having an average molecular weight of 750,000 to 6,000,000.

7. The regeneration treatment apparatus according to claim 6,
wherein the portion in contact with the resin aggregate is a portion in contact with the resin aggregate once or repeatedly.

8. A washout processor comprising the regeneration treatment apparatus according to any one of claims 1 to 7.

9. A washout processor that develops an imagewise exposed flexographic printing plate precursor having a photosensitive resin layer using a washing solution of which a main component is water,
wherein a portion in contact with a used washing solution which contains a resin aggregate generated as a non-exposed portion of the imagewise exposed flexographic printing plate precursor is removed has a critical surface tension of 31 mN/m or less and a dynamic friction coefficient of 0.2 or less.

10. The washout processor according to claim 9,
wherein a portion in contact with the resin aggregate is composed of at least one selected from groups consisting of perfluoroalkoxy alkane, polytetrafluoroethylene, and polyethylene having an average molecular weight of 700,000 or more.

11. The washout processor according to claim 9,
wherein a portion in contact with the resin aggregate is composed of at least one selected from groups consisting of polyethylene having an average molecular weight of 750,000 to 6,000,000.

12. A washout processor that develops an imagewise exposed flexographic printing plate precursor having a photosensitive resin layer using a washing solution of which a main component is water,
wherein a portion in contact with a used washing solution which contains a resin aggregate generated as a non-exposed portion of the imagewise exposed flexographic printing plate precursor is removed is composed of polyethylene having an average molecular weight of 750,000 to 6,000,000.

13. The washout processor according to any one of claims 8 to 12,
wherein a portion in contact with the resin aggregate is a portion in contact with the resin aggregate once or repeatedly.

14. The washout processor according to any one of claims 8 to 13, further comprising:
a developing tank that develops an imagewise exposed flexographic printing plate precursor,
wherein a portion in contact with the resin aggregate is a gas-liquid interface of the washing solution at an inner wall surface of the developing tank.

15. A manufacturing method of a flexographic printing plate, the manufacturing method comprising developing an imagewise exposed flexographic printing plate precursor using the used washing solution from which the resin aggregate is removed using the regeneration treatment apparatus according to any one of claims 1 to 7.

16. A manufacturing method of a flexographic printing plate, the manufacturing method comprising developing an imagewise exposed flexographic printing plate precursor using the washout processor according to claim 8.
